# EUROPEAN PATENT APPLICATION

(11) **EP 4 279 452 A1**
(43) Date of publication of application: **22.11.2023**
(21) Application number: 22173980.8
(22) Date of filing: 18.05.2022
(51) Int. Cl.: C01B 32/963, C01B 32/977, C23C 16/32

(54) **SIC GROWTH SUBSTRATE, CVD REACTOR AND METHOD FOR THE PRODUCTION OF SIC**

(71) Applicant: Zadient Technologies SAS, 73800 Sainte-Hélène-du-Lac (FR)
(72) Inventor: CERAN, Kagan, 73190 Saint Baldoph (FR); SCHAAF, Friedrich, 06116 Halle (DE)
(74) Representative: Kehl, Ascherl, Liebhoff & Ettmayr Patentanwälte Partnerschaft mbB

(57) **Abstract**

The present invention concerns a SiC growth substrate for growing SiC in a CVD reactor. The SiC growth substrate comprises a main body, a first power connection (and a second power connection, wherein the main body has a main body length, wherein the main body length (ML) extends between the first power connection and the second power connection, wherein the first power connection is configured to conduct power into the main body for heating the main body and wherein the second power connection is configured to conduct electric power conducted via the first power connection into the main body out of the main body, wherein the main body forms a physical structure, wherein the physical structure forms a deposition surface for deposition of SiC for growing a SiC crust, wherein the physical structure is configured to resist forces generated during growth of the SiC crust having a minimal thickness of at least 1cm for preventing cracking of the physical structure due to the generated forces at least in a defined volume section of the physical structure, wherein the defined volume section is formed between a first plane and a second plane, wherein the first plane is perpendicular to the main body length and wherein the second plane is perpendicular to the main body length, wherein the distance between the first plane and the second plane is at least 5% of the main body length.

## Description

The present invention refers according to claim 1 to a SiC growth substrate, according to claim 19 to a CVD reactor and according to claim 20 to a method for the production of SiC.

Power electronics based on silicon carbide (SiC) wafers exhibit improved performance over those based on conventional silicon (Si) wafers, primarily due to the wider bandgap of SiC which allows it to operate at higher voltages, temperatures, and frequencies. With the worldwide transition to electric vehicles (EVs) gaining momentum, there is an increased interest in high performance SiC based power electronics, but SiC wafers remain considerably more expensive than Si wafers.

Currently, the prevailing method for commercial production of SiC single crystals is physical vapor transport (PVT).

Presently, industrial SiC source material used is produced via the commercial Acheson process and then further purified by powdering and acid leaching. The Acheson process is yet the only known process for the production of SiC source material in industrial scale. Acid leaching is used to extract trace metals from the SiC but only penetrates to a depth of approximately less than 1 micron from the surface of the particles. Thus, the particles need to be small enough so that this penetration layer constitutes a sufficient ratio of the total volume of the particle. Consequently, the power SiC particles typically need to have an average particle size of 200-300 microns. At this average particle size, this material can only be purified to approximately 99.99% or 99.999%, otherwise referred to as 4N or 5N purity respectively.

In some cases, silicon powder is used, in particular mixed with graphite powder and sintered, to produce SiC source material. Powdering SiC material creates high surface area for contamination during handling and exposure to air. The main contaminants of concern are trace metals, nitrogen, and oxygen.

Despite the only moderate 4N or 5N purity of these acid leached or sintered SiC materials they are expensive and contribute significantly to the overall high cost of resultant SiC wafers. The moderate purity also contributes to high wafer costs in that impurities cause defects in crystals that must then be discarded rather than sliced into wafers. In other words, impurities in the source material contribute to low crystal yield.

The presence of trace metals in SiC source material are considered to be a major root cause for crystal defects of the resulting single crystal SiC boule grown by PVT. Currently the quality of singly crystal SiC boule in terms of crystal defects like dislocations is orders of magnitude below that of other semiconducting crystals like silicon or GaAs. These crystal defects lead to unwanted electrical shortcuts in SiC electrical devices (which in most cases are vertical devices) and diminish the electrical device yield. It is therefore mandatory to find a better solution to prevent crystal defects resulting from source material impurities.

Furthermore, metal impurities in a SiC wafer manufactured from a single crystal SiC boule interact with the subsequent implant and doping technologies to manufacture a SiC electrical device, which could lead to device failure and diminishes electrical devices yield.

Furthermore, concentrations or bands of impurities, in particular nitrogen, develop in the boule which then results in wafers from different heights in the same boule with conductivity that may be outside of the required range or varies from one side of a wafer to another. In the case of semi-insulating SiC wafers for RF applications, very low conductivity is required and therefore very low concentrations of trace metals and nitrogen are permissible in the wafer. In the case of conductive SiC wafers for power applications, a certain amount of conductivity is required. But this conductivity is achieved uniformly throughout the SiC boule by providing nitrogen gas into the PVT crucible during the entire growth time.

Form factor of the SiC source material is also important in PVT growth. Powder source material provides high initial surface area for sublimation and therefore a high initial sublimation rate. A high sublimation rate can be uneconomic in the event that all the vaporized SiC species cannot be incorporated into the crystal and become parasitic polycrystalline depositions on other parts of the crucible. Worse, high concentrations of SiC species in front of the crystal growth face can lead to nucleation in the vapor phase and formation of amorphous or polycrystalline inclusions in the monocrystalline boule. Over time, the powder source material tends to sinter together creating a single block of material with substantially reduced surface area and therefore tailing sublimation rate. This spiking and tailing sublimation curve for power source material results in overall slow growth with the possibility of defects in the grown crystal. Finally, powder source material, has a low tap density of approximately 1.2 g/cm³ which limits the mass of material that can be loaded into the crucible and therefore the size of the crystal that can be grown.

Document GB1128757 discloses a method for the depositing of a thin coating of SiC. However, the teaching of GB1128757 does not relate to a method for the production of large quantities of SiC as PVT source material.

DE1184738 (B) discloses a method for producing silicon carbide crystals in monocrystalline and polycrystalline form by reacting silicon halides with carbon tetrachloride in a molar ratio of 1:1 in the presence of hydrogen on heated graphite bodies. In this process, a mixture of 1 volume percent silicon chloroform, 1 volume percent carbon tetrachloride and hydrogen is first passed over the graphite body at a flow rate of 400 to 600 l/h until a compact silicon carbide layer is formed on the graphite body, and then at a flow rate of 250 to 350 l/h over the deposition body at 1500 to 1600°C.

This state of the art is disadvantageous because it does not meet today's requirements for high-purity SiC cheaply produced in large scale industrial processes. SiC is used in many areas of technology, in particular power applications and/or electromobility, to increase efficiency. In order for the products requiring SiC to be accessible to a mass market, the manufacturing costs must decrease and/or the quality must increase.

It is therefore the object of the present invention to provide a low-cost supply of silicon carbide (SiC). Additionally, or alternatively, high purity SiC shall be provided. Additionally, or alternatively SiC shall be provided very fast. Additionally, or alternatively SiC shall be producible very effectively. Additionally, or alternatively, monocrystalline SiC having advantageous properties shall be produced.

The before mentioned object is solved by a SiC growth substrate according to claim 1. Such a SiC growth substrate is preferably configured for growing SiC in a CVD reactor and preferably at least comprises a main body, a first power connection and a second power connection, wherein the main body has a main body length, wherein the main body length extends between the first power connection and the second power connection, wherein the first power connection is configured to conduct power into the main body for heating the main body and wherein the second power connection is configured to conduct electric power conducted via the first power connection into the main body out of the main body, wherein the main body forms or represents or is a physical structure, wherein the physical structure forms a deposition surface for deposition of SiC for growing a SiC crust, wherein the physical structure is configured to resist forces generated during growth of the SiC crust having a minimal thickness of at least 1cm or to prevent generating of forces during growth of the SiC crust having a minimal thickness of at least 1cm for preventing cracking of the physical structure due to the generated forces at least in a defined volume section of the physical structure, wherein the defined volume section is formed between a first plane and a second plane, wherein the first plane is perpendicular to the main body length and wherein the second plane is perpendicular to the main body length, wherein the distance between the first plane and the second plane is at least 5% of the main body length.

This solution is beneficial since it was found that a temperature difference between the temperature of the deposition surface and the center of the SiC growth substrate increases the larger the distance between the center of the SiC growth substrate and the deposition surface becomes. Due to a large temperature difference physical differences become relevant in view of mechanical stability. Therefore, the present invention provides a solution for compensating physical differences and/or for avoiding physical differences.

Further preferred embodiments of the present invention are described in the following specification parts.

The physical structure is according to a preferred embodiment of the present invention configured to resist forces generated during growth of the SiC crust having a minimal thickness of at least 3cm for preventing cracking of the physical structure due to the generated forces. This embodiment is beneficial since the temperature differences between the center of the SiC growth substrate and the deposition surface is larger compared to the case in which the thickness of the of the SiC crust 1 cm.

The physical structure is according to a further preferred embodiment of the present invention configured to resist forces generated during growth of the SiC crust having a minimal thickness of at least 5cm for preventing cracking of the physical structure due to the generated forces. This embodiment is beneficial since the temperature differences between the center of the SiC growth substrate and the deposition surface is larger compared to the case in which the thickness of the of the SiC crust 3 cm.

The physical structure comprises according to a further preferred embodiment of the present invention carbon fibers. This embodiment is beneficial since carbon fibers can heated to temperatures above 1500°C or above 1800°C or between 1400°C and 2000°C. Furthermore, high tensile loads can be applied to carbon fibers. Carbon fibers have several advantages including high stiffness, high tensile strength, high strength to weight ratio, high chemical resistance, high temperature tolerance and low thermal expansion. The atomic structure of carbon fiber is similar to that of graphite, consisting of sheets of carbon atoms arranged in a regular hexagonal pattern (graphene sheets), the difference being in the way these sheets interlock. Graphite is a crystalline material in which the sheets are stacked parallel to one another in regular fashion. The intermolecular forces between the sheets are relatively weak Van der Waals forces, giving graphite its soft and brittle characteristics.

The physical structure is according to a further preferred embodiment of the present invention formed by a carbon fiber composite material. This embodiment is beneficial since the fiber orientation with carbon fiber composite materials covers at least two directions and therefore allows also compensation forces in multiple directions. An example of a preferred carbon fiber composite material is e.g. SIGRABOND Standard from SGL Carbon GmbH.

The physical structure formed by the carbon fiber composite material has preferred embodiment of the present invention a tensile strength above 50 MPa (cf. DIN IEC 60413/501) and/or a flexural strength above 50 MPa. This embodiment is beneficial since high tensile loads resulting from high temperature differences resulting from thick SiC crusts can be compensated.

The physical structure has according to a preferred embodiment of the present invention at least in sections and preferably along more than 50% of the length of the physical structure and most preferably entirely a band-like shape, wherein the band like shape forms a cross-section having a width W and a depth D, wherein width W is at least 2 times depth D and preferably at least 3 times and highly preferably at least 5 times and most preferably up to or exactly or more than 10 times. This embodiment is beneficial since the size of the deposition surface is significantly larger compared to a cylindrical shape. Therefore, SiC deposition can be carried out much faster compared to a smaller deposition surface. Width W is preferably smaller than 1.5 cm, in particular smaller than 1 cm or smaller than 0,5 cm, in particular less than 3mm or less than 2mm or less than 1mm, and depth D is larger than 3cm, in particular larger than 5cm or larger than 8cm.

The physical structure has according to a preferred embodiment of the present invention at least in sections and preferably along more than 50% of the length of the physical structure and most preferably entirely a tubular shape, wherein the tubular shape forms a cross-section having an average wall thickness of less than 5cm and preferably of less than 2cm and particular preferably of less than 1cm. This embodiment is beneficial since - compared to a solid rod - less energy is needed to heat the deposition surface to the same temperature.

The physical structure is according to a preferred embodiment of the present invention formed by a SiC element, in particular a rod or tube or blade, in particular a polycrystalline SiC element. This embodiment is beneficial since the SiC element and the SiC crust have the same or very similar Coefficient of Thermal Expansion, thus generating of forces due to temperature differences can be reduces or prevented.

The SiC element comprises according to a preferred embodiment of the present invention more than 75% [mass] and preferably more than 95% [mass] and highly preferably more than 99% [mass] SiC. This embodiment is beneficial since the Coefficient of Thermal Expansion is closes to the Coefficient of Thermal Expansion of the SiC crust the more SiC the SiC element comprises.

According to a further preferred embodiment of the present invention the SiC of the SiC growth substrate has a thermal expansion coefficient at 1800°C of less than 5.7 ×10⁻⁶K⁻¹, in particular of 5.6 to 5.7 10⁻⁶K⁻¹ at 1600°C to 2000°C.

The SiC growth substrate has according to a preferred embodiment of the present invention impurities of less than 10ppm (weight) of the substance N and of less than 1000 ppb (weight), in particular of less than 500 ppb (weight), of each of the substances B, Al, P, Ti, V, Fe, Ni. The SiC growth substrate preferably has impurities of less than 2ppm (weight) of the substance N and of less than 100 ppb (weight) of each of the substances B, Al, P, Ti, V, Fe, Ni. The SiC growth substrate alternatively or additionally has impurities of less than 10 ppb (weight) of the substance Ti. Alternatively, the SiC growth substrate has impurities of less than 10ppm (weight) of the substance N and of less than 1000 ppb (weight), in particular of less than 500 ppb (weight), of the sum of all of the metals Ti, V, Fe, Ni. This embodiment is beneficial since the produced SiC can be used as source material in a PVT process for the production of monocrystalline SiC.

The physical structure is according to a preferred embodiment of the present invention a single piece. This embodiment is beneficial since a very homogeneous SiC crust can be formed.

The physical structure is according to a preferred embodiment of the present invention formed by multiple pieces, wherein at least some and highly preferably most and most preferably all of the multiple pieces are preferably coupled to each other by means of a form closure and/or a force closure. This embodiment is beneficial since the individual pieces are cheaper compared to a single piece. Furthermore, handling of the individual pieces before forming the SiC growth substrate is also easy.

The physical structure is according to a preferred embodiment of the present invention formed by multiple pieces, wherein at least some and preferably most and highly preferably all of the multiple pieces are made of a material having a first Coefficient of Thermal Expansion (CTE), wherein the first Coefficient of Thermal Expansion is different to a Coefficient of Thermal Expansion of polycrystalline SiC. The first Coefficient of Thermal Expansion is at least 0,1 10⁻⁶ K⁻¹ and preferably 0,5 10⁻⁶ K⁻¹ and most preferably at least 0,1 10⁻⁶ K⁻¹ different from the Coefficient of Thermal Expansion of polycrystalline SiC. This embodiment is beneficial since the SiC growth substrate can be made of different material, e.g. tungsten or graphite.

The multiple pieces comprise according to a preferred embodiment of the present invention at least two pieces of a main piece type and at least one piece of a connecting piece type, wherein the at least two main pieces are coupled by the at least one connecting piece, wherein the pieces of the main piece type have a tubular-like or rod-like or blade-like shape and wherein at least most of the pieces of the main piece type are longer compared to the pieces of the connecting piece type. This embodiment is beneficial since the maximal thermal expansion of each section is below a defined limit even in case a SiC crust of thickness of more than 1cm or preferably more than 3cm or most preferably more than 5cm is formed and even in case the temperature difference between the deposition surface and the center of the SiC growth substrate is more than 10°C or more than 30°C or more than 50°C or more than 100°C or between 50°C and 400°C, in particular between 70°C and 250°C.

The length of each of the at least two pieces of the main piece type is according to a preferred embodiment of the present invention below 100cm and above 5cm and preferably below 90cm and above 10cm and particular preferably below 85cm and above 15cm and most preferably below 80cm and above 20cm.

At least two pieces of the pieces of the main piece type and preferably most of the pieces of the main piece type and most preferably all of the pieces of the main piece type are according to a preferred embodiment of the present invention made of graphite.

A first piece of the at least two pieces of the main piece type has according to a preferred embodiment of the present invention a first central axis and a second piece of the at least two pieces of the main piece type has a second central axis, wherein the first central axis and the second central axis are arranged parallel to each other and highly preferably not coaxial. Highly preferably first central axis and the second central axis are arranged in a distance to each other of more than 5cm and preferably of more than 8cm and particular preferably of more than 12cm and most preferably of more than 15cm or between 10cm and 30cm, in particular between 11cm and 25cm or between 12cm and 20cm. This embodiment is beneficial since the thermal expansion of the individual pieces is decoupled from each other.

The physical structure forms according to a preferred embodiment of the present invention a U-shape. This embodiment is beneficial since the electrodes can be arranged on one side respectively in one wall member respectively bottom member.

The above-mentioned object is also solved by a CVD reactor according to claim 18. A CVD reactor according to the present invention preferably comprises a process chamber, wherein the process chamber is at least surrounded by a base plate, a side wall section and a top wall section, a gas inlet unit for feeding one feed-medium or multiple feed-mediums into a reaction space of the process chamber for generating a source medium, wherein the gas inlet unit is coupled with at least one feed-medium source, wherein a Si and C feed-medium source provides at least Si and C, in particular SiCl3(CH3), and wherein a carrier gas feed-medium source provides a carrier gas, in particular H2, or wherein the gas inlet unit is coupled with at least two feed-medium sources, wherein a Si feed medium source provides at least Si and wherein a C feed medium source provides at least C, in particular natural gas, Methane, Ethane, Propane, Butane and/or Acetylene, and wherein a carrier gas medium source provides a carrier gas, in particular H2, one or multiple SiC growth substrate according to claims 1 to 18, in particular more than 3 or 4 or 6 or 8 or 16 or 32 or 64 or up to 128 or up to 256, are arranged inside the process chamber for depositing SiC, wherein each SiC growth substrate comprises a first power connection and a second power connection, wherein the first power connections are first metal electrodes and wherein the second power connections are second metal electrodes, wherein the first metal electrodes and the second metal electrodes are preferably shielded from the reaction space, wherein each SiC growth substrate is coupled between at least one first metal electrode and at least one second metal electrode for heating the outer surface of the SiC growth substrates or the surface of the deposited SiC to temperatures between 1300°C and 1800°C, in particular by means of resistive heating and preferably by internal resistive heating.

According to a preferred embodiment of the present invention each SiC growth substrate comprises a first power connection and a second power connection, wherein the first power connections are first metal electrodes and wherein the second power connections are second metal electrodes, wherein the first metal electrodes and the second metal electrodes are preferably shielded from a reaction space inside the process chamber, wherein each SiC growth substrate is coupled between at least one first metal electrode and at least one second metal electrode for heating the outer surface of the SiC growth substrates or the surface of the deposited SiC to temperatures between 1300°C and 1800°C, in particular by means of resistive heating and preferably by internal resistive heating. This embodiment is beneficial since the SiC growth substrates can be heated in a very effective manner.

Since flowing electrical current requires an inlet and an outlet electrode, these electrodes are preferably disposed in multiple pairs, such as preferably 12 pairs or 18 pairs or 24 pairs or 36 pairs or more. A deposition substrate respectively SiC growth substrate is preferably attached to each electrode, in particular metal electrode, of an electrode pair (first and second metal electrode) and the substrates are connected at the top by a cross member respectively bridge of the same material as the substrate to complete the electrical circuit. The deposition substrates respectively SiC growth substrates are preferably attached to the electrodes via an intermediate piece respectively chuck. The chuck preferably has a reducing cross-sectional area extending from the electrode to the deposition substrate so that electrical current is concentrated and resistive heating increases. The purpose of the chuck is to maintain a temperature below deposition temperature at the lower wider end and to maintain a temperature above deposition temperature at the upper narrower end. The chuck is preferably conical in shape. The chuck, deposition substrate, and bridge are preferably made from graphite or more preferably from high purity graphite with total ash content of less than 50000 ppm and preferably less than 5000 ppm and highly preferably less than 500 ppm. The deposition substrate is also preferably made from SiC. According to a further aspect of the present invention contact between first metal electrode and SiC growth substrate is in a different plane than the contact between second metal electrode and SiC growth substrate. The second electrode can preferably be arranged or provided on an opposite side of the process chamber and/or as part of the bell jar.

The process chamber is according to a preferred embodiment of the present invention at least surrounded by a base plate, a side wall section and a top wall section. This embodiment is beneficial since the process chamber can be isolated respectively defined by the base plate, side wall section and top wall section. The baseplate is preferably also disposed with a plurality of gas inlet ports and one gas outlet port or multiple a gas outlet ports. The gas inlet ports and outlet port are arranged so as to create an optimal flow of feed gas inside the CVD reactor respectively SiC production reactor, in particular SiC PVT source material production reactor, such that fresh feed gas is continually brought in contact with the deposition surfaces on the deposition substrates.

The gas inlet unit is according to a further preferred embodiment of the present invention coupled with at least one feed-medium source, wherein the one feed-medium source is a Si and C feed-medium source, wherein the Si and C feed-medium source provides at least Si and C, in particular SiCl3(CH3), and wherein a carrier gas feed-medium source provides a carrier gas, in particular H2, or wherein the gas inlet unit is coupled with at least two feed-medium sources, one of the two feed-medium sources is a Si feed medium source, wherein the Si feed medium source provides at least Si, in particular a Si gas according to the general formula SiH4-y Xy ( X=[CI, F, Br, J] und y= [0..4], and another one of the two feed-medium sources is a C feed medium source, wherein the C feed medium source provides at least C, in particular natural gas, Methane, Ethan, Propane, Butane and/or Acetylene, and wherein a carrier gas medium source provides a carrier gas, in particular H2.

Alternatively the first feed medium is a Si feed medium, in particular a Si gas according to the general formula SiH4-y Xy ( X=[CI, F, Br ,J] und y= [0..4], wherein the gas inlet unit is coupled with at least one feed-medium source, wherein a C feed medium source provides at least C, in particular the C feed medium source provided a second feed medium, wherein the second feed medium is a C feed medium, in particular natural gas, Methane, Ethan, Propane, Butane and/or Acetylene, and wherein a carrier gas medium source provides a third feed medium, wherein the third feed medium is a carrier gas, in particular H2.

Natural gas preferably defines a gas having multiple components, wherein the largest component is methane, in particular more than 50% [mass] is methane and preferably more than 70%[mass] is methane and highly preferably more than 90%[mass] is methane and most preferably more than 95%[mass] or more than 99%[mass] is methane.

Thus, the SiC production reactor respectively the CVD SiC apparatus is preferably also equipped with a feed gas unit respectively a medium supply unit for feeding the feed gas to the gas inlet unit. The feed gas unit respectively medium supply unit ensures the feed gases are heated to the right temperature and mixed in the right ratios before they are pumped into the CVD reactor respectively SiC production reactor, in particular SiC PVT source material production reactor. The feed gas unit respectively medium supply unit begins with pipes and pumps which transport feed gases from their respective sources, in particular storage tanks, to the proximity of the CVD reactor respectively SiC production reactor, in particular SiC PVT source material production reactor. Here the mass flowrate of preferably each feed gas is preferably controlled by a separate mass flow meter connected to an overall process control unit so that the correct ratio of the various feed gases can be achieved. The separate feed gases are then preferably mixed in a mixing unit, in particular of the medium supply unit, and pumped into the CVD reactor respectively SiC production reactor, in particular SiC PVT source material production reactor, via the gas inlet unit, in particular via multiple gas inlet ports of the gas inlet unit. Preferably the feed gas unit respectively medium supply unit is able to mix three feed gases including an Si-bearing gas such as STC and/or SiCl₃H (wherein SiCl₃H can be named TCS), a C-bearing gas such as methane, and a carrier gas such as H. In another preferred embodiment of the invention, there is a feed gas that bears both Si and C such as SiCl3(CH3) (wherein SiCl3(CH3) can be alternatively named MTCS), and the feed gas unit mixes two gases instead of three, namely MTCS and H. It should be noted that STC, TCS, and MTCS are liquid at room temperature. As such a preheater can be required upstream of the gas inlet unit, in particular upstream of the feed gas unit respectively medium supply unit to first heat these feed liquids so that they become feed gases ready for mixing with the other feed gases.

Preferably the gases are mixed such that there is a 1:1 atomic ratio between Si and C. In some cases, it may be more preferably to mix the gases such that there is a different atomic ratio between the Si and the C. Sometimes it is desirable to maintain the deposition surfaces at the higher end of the deposition temperature range of 1300 to 1600°C to achieve a faster deposition rate. However, in such a condition there is the possibility of excess C deposition in the SiC. This can be moderated by mixing the feed gases such that the Si:C ratio is higher than 1:1, preferably 1:1.1 or 1:1.2, or 1:1.3. Conversely, sometimes it is desirable to maintain the deposition surfaces at the lower end of the deposition temperature range to achieve a slow stress-free deposition. In such a condition there is the possibility of excess Si deposition in the SiC. This can be moderated by mixing the feed gases such that the Si:C ratio is lower than 1:1, preferably 1:0.9, or 1:0.8, or 1:0.7.

A further important consideration for the feed gas mixture is the atomic ratio of H to Si and C. Excess H can dilute the Si and C and reduce the deposition rate. It can also increase the volume of vent gases exiting the CVD reactor respectively SiC production reactor, in particular SiC PVT source material production reactor, and complicate any treatment and recycling of these vent gases. On the other hand, insufficient H can retard the chemical reaction chain that results in the deposition of SiC. The molar ratio of H₂ to Si is preferably in the range of 2:1 to 10:1 and more preferably between 4:1 and 6:1.

According to a further embodiment of the present invention more or up to 4 or preferably 6 or 8 more or up to or highly preferably more or up to 16 or 32 or 64 or most preferably up to 128 or up to 256 SiC growth substrates can be arranged inside one SiC production reactor.

This embodiment is beneficial since the output of the SiC reactor can be significantly increased by adding additional SiC growth substrates.

A control unit for setting up a feed medium supply of the one feed-medium or the multiple feed-mediums into the process chamber is provided according to a further preferred embodiment of the present invention, wherein the control unit is configured to set up the feed medium supply between a minimum amount of feed medium supply [mass] per min. and a maximum amount of feed medium supply [mass] per min., wherein the minimum amount of feed medium supply [mass] per min. corresponds to a deposited minimum amount of Si [mass] and a minimum amount of C [mass] at a defined mass growth rate, wherein the defined mass growth rate is larger than 0.1 g per hour and per cm2 of the SiC growth surface, wherein the maximum amount of feed medium supply per min is up to 30% [mass] or to 20% [mass] or up to 10% [mass] or up to 5% [mass] or up to 3% [mass] higher compared to the minimum amount of feed medium supply. This embodiment is beneficial since the feed medium supply can be controlled in dependency of the desired SiC conditions.

The control unit is according to a further preferred embodiment of the present invention configured to control the current flow through the SiC growth substrate/s to maintain the surface temperature of the SiC growth substrate/s or to set up the surface temperature of the deposited SiC. This embodiment is beneficial since the deposition of the SiC can be maintained by setting up the required temperature conditions.

The control unit is according to a further preferred embodiment of the present invention configured to control the current flow and the amount of feed medium supply for at least one hour and preferably for at least two hours or four hours or six hours to continuously deposit SiC with the defined surface growth rate and/or with a defined radial growth rate. This embodiment is beneficial since large SiC solids can be generated.

The control unit is according to a further preferred embodiment of the present invention a hardware arrangement configured to modify the current flow, wherein modification of the current flow within a first defined time span from the start of a production run are predefined. This embodiment is beneficial since the hardware can be adapted to a defined process, thus additional sensors are not necessary. The first-time span is preferably one hour or more than one hour or up to 60% of the duration of the production run or up to 80% of the duration of the production run or up to 90% of the duration of the production run or up to 100% of the duration of the production run. The hardware arrangement is preferably configured to modify the amount of feed medium supply, wherein modification of the amount of feed medium supply within a second defined time span from the start of a production run is predefined, wherein the second time span is one hour or more than one hour or up to 60% of the duration of the production run or up to 80% of the duration of the production run or up to 90% of the duration of the production run or up to 100% of the duration of the production run.

At least one sensor is according to a further preferred embodiment of the present invention provided, wherein the sensor is coupled with the control unit to provide sensor signals or sensor data to the control unit, wherein the control unit controls current flow and the amount of feed medium supply in dependency of the sensor signals or sensor data of the at least one sensor, wherein the at least one sensor is a temperature sensor for monitoring the surface temperature of at least one of the substrates. At least one temperature sensor is preferably a camera, in particular an IR camera, wherein preferably multiple temperature sensors are provided, wherein the number of temperature sensors corresponds to the number of SiC growth substrates, wherein per 10 SiC growth substrates at least 1, in particular 2 or 5 or 10 or 20, temperature sensor is provided or wherein per 5 SiC growth substrates at least 1, in particular 2 or 5 or 10 or 20, temperature sensor is provided or wherein per 2 SiC growth substrates at least 1, in particular 2 or 5 or 10 or 20, temperature sensor is provided, wherein the temperature sensor preferably outputs temperature sensor signals or temperature sensor data representing a measured temperature, in particular surface temperature. This embodiment is beneficial since the conditions inside the SiC production reactor can be immediately adjusted.

At least one substrate diameter measuring sensor is according to a further preferred embodiment of the present invention provided, wherein the substrate diameter measuring sensor is preferably an IR camera for determining substrate diameter growth, wherein the substrate diameter measuring sensor preferably outputs diameter measuring signals or diameter measuring data representing a measured substrate diameter or a variation of a measured substrate diameter and/or a resistance determination means for determining electrical resistance variation for determining substrate diameter growth, wherein the substrate diameter measuring sensor preferably outputs diameter measuring signals or diameter measuring data representing a measured substrate diameter or a variation of a measured substrate diameter. This embodiment is beneficial since in dependency of the measured data or values parameter like current flow or feed medium supply can be amended, in particular increased.

One valve or multiple vales is/are according to a further preferred embodiment of the present invention provided, wherein the one or multiple valves are configured to be actuated in dependency of the measured temperature, in particular in dependency of the temperature sensor signals or temperature sensor data and/or wherein the one or multiple valves are configured to be actuated in dependency of the measured substrate diameter, in particular in dependency of the diameter measuring signals or diameter measuring data. The one valve or the multiple valves can be part of the gas inlet unit. This embodiment is beneficial since a feed medium flow and/or vent gas flow can be controlled. Thus, the control unit is according to a further preferred embodiment of the present invention configured to increasing the electrical energizing of the at least one SiC growth substrate over time, in particular to heat a surface of the deposited SiC to a temperature between 1300°C and 1800°C

The power supply unit for providing the current is according to a further preferred embodiment of the present invention configured to provide current in dependency of the diameter measuring signals or diameter measuring data. This embodiment is beneficial since a feed medium flow and/or vent gas flow can be controlled.

Thus, the control unit is preferably configured to receive the temperature sensor signals or temperature sensor data and/or the diameter measuring signals or diameter measuring data and to process the temperature sensor signals or temperature sensor data and/or the diameter measuring signals or diameter measuring data and/or to control the one or multiple vales and/or the power supply unit.

The control unit is according to a further preferred embodiment of the present invention configured to control feed-medium flow and temperature of the surface of the deposited SiC for depositing SiC at the set deposition rate, in particular perpendicular deposition rate, for more than 2hours, in particular for more or up to 3 hours or for more or up to 5 hours or for more or up to 8 hours or preferably for more or up to 10 hours or highly preferably for more or up to 15 hours or most preferably for more or up to 24 hours or up to 72h or up to 100h. This embodiment is beneficial since a large amount of SiC can be grown.

The base plate comprises according to a further preferred embodiment of the present invention at least one cooling element, in particular a base cooling element, for preventing heating the base plate above a defined temperature and/or the side wall section comprises at least one cooling element, in particular a bell jar cooling element, for preventing heating the side wall section above a defined temperature and/or the top wall section comprises at least one cooling element, in particular a bell jar cooling element, for preventing heating the top wall section above a defined temperature.

This embodiment is beneficial since the present invention discloses a CVD SiC apparatus for large volume commercial production of ultrapure bulk CVD SiC. The central equipment in the CVD SiC apparatus is the CVD unit respectively CVD reactor respectively SiC production reactor, in particular SiC PVT source material production reactor. The CVD reactor respectively SiC production reactor, in particular SiC PVT source material production reactor, preferably comprises a cooling element, in particular a double walled fluid, in particular water or oil, cooled lower housing respectively baseplate and a double walled liquid cooled upper housing respectively bell jar. The inner walls of the baseplate and in particular the bell jar are preferably made of materials with service temperatures compatible with the operating temperatures of the CVD reactor respectively SiC production reactor, in particular SiC PVT source material production reactor. In particular, the inner wall of the bell jar can be made from stainless steel. Preferably, this inner wall is additionally or alternatively coated with a reflective coating such as preferably silver or preferably gold to reflect back radiant energy and minimize heat losses and therefore electricity costs. The bell jar and/or the base plate are preferably made of stainless steel that withstands high temperatures. However, current high temperature steels with additions of chromium, nickel, cerium or yttrium only withstand temperatures up to 1300°C (in air). As an example, the steel EN 1.4742 (X10CrAlSi18) is heat resistant up to temperatures of 1000°C. In another example the alloy steel EN 2.4816 (UNS N06600) withstands temperature of 1250°C, melts above 1370°C, however its tensile strength drops to less than 10% of its room temperature value at temperatures above 1100°C. Therefore, none of these steels can withstand the enormous temperature required for SiC absorption of more than 1300°C.

It is therefore beneficial to provide a cooling element to reduce the temperature of the bell jar and/or the base plate to a level that is acceptable for the usage of high temperature stainless steel.

The baseplate is preferably disposed with one or multiple fluid, in particular water or oil, cooled electrodes for providing electrical through-connections to the CVD reactor respectively SiC production reactor, in particular SiC PVT source material production reactor, for the purpose of resistively heating deposition substrates. The cooling element is according to a further preferred embodiment of the present invention an active cooling element.

The base plate and/or side wall section and/or top wall section comprises according to a further preferred embodiment of the present invention a cooling fluid guide unit for guiding a cooling fluid, wherein the cooling fluid guide unit is configured limit heating of the base plate and/or side wall section and/or top wall section to a temperature below 1300°C. This embodiment is beneficial since a metal, in particular steel bell jar can be provided. A steel bell jar is beneficial since it can be produced significant larger compared to quartz bell jars.

A base plate and/or side wall section and/or top wall section sensor unit is provided according to a further preferred embodiment of the present invention to detect temperature of the base plate and/or side wall section and/or top wall section and to output a temperature signal or temperature data, and a fluid forwarding unit is provided for forwarding the cooling fluid through the fluid guide unit. This embodiment is beneficial since a continuous cooling can take place without loss or contamination of the cooling fluid and/or the process chamber.

The fluid forwarding unit is according to a further preferred embodiment of the present invention configured to be operated in dependency of the temperature signal or temperature data provided by the base plate and/or side wall section and/or top wall section sensor unit. This embodiment is beneficial since metal impurities can be avoided in case the bell jar and/or base plate are operated at temperatures below 1000°C and preferably below 800°C and highly preferably below 400°C respectively in case the bell jar and/or base plate are cooled to temperatures below 1000°C and preferably below 800°C and highly preferably below 400°C.

The cooling fluid is according to a further preferred embodiment of the present invention oil or water, wherein the water preferably comprises at least one additive, in particular corrosion inhibiter/s and/or antifouling agent/s (biocides). This embodiment is beneficial since the cooling liquid can be modified to avoid defects or contaminations of the SiC production reactor.

The cooling element is according to a further preferred embodiment of the present invention a passive cooling element. This embodiment is beneficial since a passive cooling element does not require constant monitoring.

The cooling element is according to a further preferred embodiment of the present invention at least partially formed by a polished steel surface of the base plate, the side wall section and/or the top wall section. The cooling element is according to a further preferred embodiment of the present invention a coating, wherein the coating is formed above the polished steel surface and wherein the coating is configured to reflect heat. The coating is according to a further preferred embodiment of the present invention a metal coating or a comprises metal, in particular silver or gold or chrome, or alloy coating, in particular a CuNi alloy. The emissivity of the polished steel surface and/or of the coating is according to a further preferred embodiment of the present invention below 0.3, in particular below 0.1 or below 0.03. This embodiment is beneficial since due to the polished surface and/or the coating a high amount of heat radiation can be reflected back to the SiC growth surface.

Thus, at least one section of the bell jar surface and/or at least one section of the base unit surface comprises according to a further preferred embodiment of the present invention a coating, in particular a reflective coating, wherein the section of the bell jar surface and/or the section of the base unit surface delimits the reaction space, wherein the coating is a metal coating, in particular comprises or consists of gold, silver, aluminum and/or platinum and/or wherein the coating is configured to reflect at least 2% or at least 5% or at least 10% or at least 20% of the radiant energy radiated during one production run onto the coating.

The base plate comprises according to a further preferred embodiment of the present invention at least one active cooling element and one passive cooling element for preventing heating the base plate above a defined temperature and/or the side wall section comprises at least one active cooling element and one passive cooling element for preventing heating the side wall section above a defined temperature and/or the top wall section comprises at least one active cooling element and one passive cooling element for preventing heating the top wall section above a defined temperature.

The side wall section and the top wall section are formed according to a further preferred embodiment of the present invention by a bell jar, wherein the bell jar is preferably movable with respect to the base plate. More than 50% [mass] of the side wall section and/or more than 50% [mass] of the top wall section and/or more than 50% [mass] of base plate is according to a further preferred embodiment of the present invention made of metal, in particular steel. This embodiment is beneficial since large steel bell jars can be manufactured causing a significant increase in process chamber volume and therefore in potential SiC material. Thus a bell jar is preferably provided, wherein the bell jar comprises according to a further preferred embodiment of the present invention a contact region for forming an interface with the base unit, wherein the interface is sealed against leakage of gaseous species, wherein the bell jar comprises a bell jar cooling unit, wherein the bell jar cooling element forms at least one channel or trench or recess for holding or guiding a bell jar cooling liquid, wherein the bell jar cooling element is configured to cool at least one section of the bell jar and preferably the entire bell jar below a defined temperature respectively to remove a defined amount of heat per min during the production run. The bell jar cooling element and/or base plate cooling element is preferably controlled by the control unit. Additionally, or alternatively the bell jar cooling element and/or base cooling element are coupled with each other to form one major cooling unit.

The base unit comprises according to a further preferred embodiment of the present invention at least one base cooling element for cooling the base unit, wherein the base cooling element forms at least one channel or trench or recess for holding or guiding a base cooling liquid. The base cooling element is according to a further preferred embodiment of the present invention arranged in an area of at least one of the first metal electrodes and preferably also in an area of at least one second metal electrode, wherein the base cooling element is configured to cool the base unit, in particular a surface of the base unit, which is arranged inside the reactor, in the area of at least one of the first metal electrodes and preferably also in the area of the at least one second metal electrode below a defined temperature respectively to remove a defined amount of heat per min from the base unit or the base cooling element is configured to cool the entire base unit during a complete production run below a defined temperature respectively to remove a defined amount of heat per min during the production run. This embodiment is beneficial since electrodes can be operated with high current without damaging the SiC reactor.

The first metal electrode and the SiC growth substrate are according to a further preferred embodiment of the present invention connected with each other via a first graphite chuck and/or the second metal electrode and the SiC growth substrate are connected with each other via a second graphite chuck. This embodiment is beneficial since the current can be introduced in a homogeneous manner into the SiC growth substrate. The first graphite chuck and/or the second graphite chuck is/are according to a further preferred embodiment of the present invention mounted to the base unit.

The first metal electrodes and second metal electrodes are according to a further preferred embodiment of the present invention sealed from the reaction chamber to avoid metal species contamination of the reaction chamber by metal species of the first metal electrodes and second metal electrodes, the first metal electrodes and second metal electrodes preferably enter the base unit from a first side of the base unit, wherein the first metal electrodes and second metal electrodes preferably extend inside the base unit to another side of the base unit, wherein the other side of the base unit is opposite to the first side, wherein the first metal electrodes and preferably the second metal electrodes extend inside the base unit to a sealing level below a process chamber surface of the base unit, wherein the process chamber surface is formed on the other side of the base unit. This embodiment is beneficial since contaminations of the reaction space can be avoided.

A sealing wall member is according to a further preferred embodiment of the present invention formed between the sealing level and the process chamber surface, wherein the sealing wall member separates the SiC growth substrate from the first metal electrode and preferably from the second metal electrode. This embodiment is beneficial since short circuiting can be prevented.

The control unit is according to a further preferred embodiment of the present invention configured to control the current flow through the SiC growth substrate/s to maintain the surface temperature of the SiC growth substrate/s or to set up the surface temperature of the deposited SiC, wherein the control unit is coupled to a power supply unit for providing the current, wherein the power supply unit is configured to receive power supply data or power supply signals provided by the control unit; and/or the feed medium supply of the one feed-medium or the multiple feed-mediums into the process chamber, wherein the control unit is coupled to a medium supply unit for providing the one feed-medium or the multiple feed-mediums to the gas inlet unit, wherein the medium supply unit is configured to receive medium supply data or medium supply signals provided by the control unit; and/or a cooling of the base unit, wherein the control unit is coupled to the base cooling element for cooling the base unit, wherein the base cooling element is configured to receive base cooling data or base cooling signals provided by the control unit, and/or a cooling of the bell jar, wherein the control unit is coupled to the bell jar cooling element for cooling the bell jar, wherein the bell jar cooling element is configured to receive bell jar cooling data or bell jar cooling signals provided by the control unit, and/or the control unit is configured to set up a deposition rate, in particular perpendicular deposition rate, of more than 200 µm/h, in particular by controlling at least the power supply unit and the medium supply unit. This embodiment is beneficial since the control unit can control multiple parameters, thus the output can be increased by operating the heating, feeding and cooling units at the same time.

The medium supply unit is according to a further preferred embodiment of the present invention configured to feed the one feed-medium or multiple feed-mediums at a pressure of more than 1 bar, in particular of more than 1.2bar or preferably of more than 1.5bar or highly preferably of more than 2bar or 3bar or 4bar or 5bar respectively of up to 10 bar or up to 20 bar, into the process chamber. Additionally, or alternatively the medium supply unit is according to a further preferred embodiment of the present invention configured to feed the one feed-medium or multiple feed-mediums and a carrier gas at a pressure of more than 1 bar, in particular of more than 1.2bar or 1.5bar or 2bar or 3bar or 4bar or 5bar, into the process chamber. This embodiment is beneficial since the material density is high inside the process chamber, thus a high amount of Si and C material reaches the SiC growth surface and therefore causes an enhanced SiC growth.

At least one SiC growth substrate and preferably multiple SiC growth substrates or all SiC growth substrates are according to a further preferred embodiment of the present invention formed like an I or E or U, wherein at least one SiC growth substrate or multiple SiC growth substrates or all SiC growth substrates are connected through the base unit, in particular the sealing wall member, with first metal electrodes and/or at least one SiC growth substrate and preferably multiple SiC growth substrates or all SiC growth substrates are formed like an I or E or U, wherein at least one SiC growth substrate or multiple SiC growth substrates or all SiC growth substrates are connected through the base unit, in particular the sealing wall member, with second metal electrodes. This embodiment is beneficial, in particular with respect to the U-shape, since the length of the SiC growth substrate can be nearly or about 2x the length of an I shape. Furthermore, the electrodes of a U-shaped SiC growth substrate can be mounted to the same wall member, in particular to a base plate.

The inlet unit comprises according to a further preferred embodiment of the present invention multiple orifices for setting up a turbulent gas flow inside the process chamber, in particular in a distance of less than 20mm or less than 10mm or less than 2mm to the surface of the SiC growth substrate or to the surface of the SiC deposited on the SiC growth substrate. Since the surface of the deposited SiC growth, in particular continuously growth, the region wherein turbulent flow has to be maintained can change. This embodiment is beneficial since due to the turbulent flow the speed of deposition can be increased, since more Si and C material reaches the SiC growth substrate surface respectively the SiC growth surface.

The control unit is according to a further preferred embodiment of the present invention configured to control the medium supply unit to feed the one feed-medium or the multiple feed-mediums into the process chamber, wherein the one feed-medium or the multiple feed-mediums comprise the following molar ratio: Si:C, wherein Si =1 and C=0.8 to 1.1 or wherein the one feed-medium or the multiple feed-mediums comprise the following atomic ratio: Si:C, wherein Si =1 and C=0.8 to 1.1. This embodiment is beneficial since the desired material ratio can be controlled and set. Thus, a control unit for setting up a feed medium supply of the one feed-medium and the carrier gas into the process chamber is provided, wherein the control unit is preferably configured to control the medium supply unit to feed the one feed-medium into the process chamber in a defined molar ratio and/or defined atomic ratio, wherein the one feed-medium and the carrier gas comprise the following defined molar ratio: Si:H, wherein Si =1 and H=2 to 10, preferably 5 to 10 and highly preferably 5 to 7, or wherein the one feed-medium and the carrier gas comprise the following defined atomic ratio: Si:H, wherein Si =1 and H=2 to 10, preferably 5 to 10 and highly preferably 5 to 7 or a control unit for setting up a feed medium supply of the multiple feed-mediums into the process chamber, wherein the control unit is configured to control the medium supply unit to feed the multiple feed-mediums into the process chamber in a defined molar ratio and/or defined atomic ratio, wherein the multiple feed-mediums comprise the following defined molar ratio: Si:C, wherein Si =1 and C=0.8 to 1.1 or wherein the multiple feed-mediums comprise the following defined atomic ratio: Si:C, wherein Si =1 and C=0.8 to 1.1.

The Si and C feed-medium source is according to a further preferred embodiment of the present invention coupled with at least one Si and C feed-medium orifice of the inlet unit and the carrier gas feed-medium source is coupled with at least one carrier gas orifice of the inlet unit, wherein the Si and C feed-medium orifice and the carrier gas orifice preferably differ from each other or the Si and C feed-medium source and the carrier gas feed-medium source are coupled with at least one common mixing and/or guiding element, in particular a pipe, wherein the at least one common mixing and/or guiding element is coupled with at least one orifice of the inlet unit.

A Si and C supply device is according to a further preferred embodiment of the present invention provided for feeding the Si and C feed medium from the Si and C feed-medium source via the at least one orifice of the gas inlet unit into the reaction space and/or a carrier gas supply device is provided for feeding the carrier gas feed medium from the carrier gas feed-medium source via the at least one orifice of the inlet unit into the reaction space and/or a feed-medium supply device is provided for a mixture of the Si and C feed-medium and the carrier gas feed-medium from the common mixing and/or guiding element via the at least one orifice of the inlet unit into the reaction space.

Alternatively a Si feed medium source is according to a further preferred embodiment of the present invention coupled with at least one Si feed-medium source orifice of the inlet unit and wherein the C feed medium source is coupled provides at least one C feed-medium source orifice of the inlet unit and wherein a carrier gas medium source is coupled with at least one carrier gas feed-medium source orifice of the inlet unit, wherein the Si feed-medium source orifice and/or the C feed-medium source orifice and/or the carrier gas feed-medium source orifice differ from each other or the Si feed medium source and the C feed medium source are coupled with at least one common mixing and/or guiding element, in particular a pipe, wherein the at least one common mixing and/or guiding element is coupled with at least one orifice of the inlet unit or the Si feed medium source and the carrier gas feed-medium source are coupled with at least one common mixing and/or guiding element, in particular a pipe, wherein the at least one common mixing and/or guiding element is coupled with at least one orifice of the inlet unit or the C feed medium source and the carrier gas feed-medium source are coupled with at least one common mixing and/or guiding element, in particular a pipe, wherein the at least one common mixing and/or guiding element is coupled with at least one orifice of the inlet unit or the Si feed medium source and the C feed medium source and the carrier gas feed-medium source are coupled with at least one common mixing and/or guiding element, in particular a pipe, wherein the at least one common mixing and/or guiding element is coupled with at least one orifice of the inlet unit.

A Si supply device is according to a further preferred embodiment of the present invention provided for feeding the Si feed medium from the Si feed-medium source via the at least one orifice of the inlet unit into the reaction space and/or a C supply device is provided for feeding the C feed medium from the C feed-medium source via the at least one orifice of the inlet unit into the reaction space and/or a carrier gas supply device is provided for feeding the carrier gas from the carrier gas feed-medium source via the at least one orifice of the inlet unit into the reaction space. The Si supply device and/or the C supply device and/or the carrier gas supply device is preferably a pump, in particular a pressure pump.

At least one outlet unit respectively vent gas outlet for removing gas from the reaction space is provided according to a further preferred embodiment of the present invention as part of the bell jar and/or as part of the base unit. This embodiment is beneficial since the used gas can be conducted out of the process chamber, thus the amount of Si and C is less affected by the presence of not vented vent gas. A pump device is according to a further preferred embodiment of the present invention coupled with the outlet unit for removing gas from the reaction space, wherein the pump device is preferably a vacuum pump.

The Si feed-medium source is according to a further preferred embodiment of the present invention configured to provide the Si feed-medium with a purity of at least 6N, in particular 7N or preferably 8N or highly preferably 9N, the C feed-medium source is configured to provide the C feed-medium with a purity of at least 6N, in particular 7N or preferably 8N or highly preferably 9N or the Si and C feed-medium source is configured to provide the Si and C feed-medium with a purity of at least 6N, in particular 7N or preferably 8N or highly preferably 9N and the carrier gas feed-medium source is configured to provide the carrier gas feed-medium with a purity of at least 6N, in particular 7N or preferably 8N or highly preferably 9N. Thus, introducing at least a first feed-medium, in particular a first source gas, into the process chamber can take place, said first feed medium comprises Si, wherein the first-feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing at least a second feed-medium, in particular a second source gas, into the process chamber, the second feed medium comprises C, wherein the second-feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing a carrier gas, wherein the carrier gas has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, or introducing one feed-medium in particular a source gas, into a process chamber, said feed medium comprises Si and C, wherein the feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing a carrier gas, wherein the carrier gas has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni. Thus, present invention discloses a CVD reactor for the production of SiC source material that is at least 8N or preferably 9N pure when initially manufactured and is preferably provided in a granular or solid form factor that minimizes subsequent surface contamination during handling and use. This ultrapure SiC source material (UPSiC) is made by the CVD reactor respectively process wherein the feed gases used can be purified to extremely high levels using effective techniques such as distillation. The SiC respectively PVT source material SiC, in particular UPSiC, is typically first deposited in the form of long thick rods and then disaggregated, in particular cut or comminuted, to shapes or sizes suitable for use in PVT crucibles. The comminution equipment is preferably made of material that do not contaminate the SiC and there is also the possibility of a further acid etching step to remove fines and ensure surface purity. This embodiment is beneficial since large and very pure particles can be produced which have advantageous sublimation properties. In case an etching step is carried out only a few atom layers (less than 1 µm, compared to 10-50 µm in Si etching) will be removed, in particular by HF/HNO3. This is beneficial since due to the etching the bluish-brownish color after annealing can be removed. Additionally or alternatively the oxide layer can also be removed with an acidic pickling acid, e.g. consisting of HCl:HF:H2O2 and/or different acid mechanism.

Chemical vapor deposition occurs when the deposition substrates respectively SiC growth substrates are heated to the deposition temperature range and the feed gas mixture is introduced into the CVD reactor respectively SiC production reactor, in particular SiC PVT source material production reactor. When the feed gas mixture contacts the heated deposition substrate the energy provided initiates a series of forward and backward chemical reactions the net result of which is deposition of solid SiC on the deposition substrate. In the case where the feed gas mixture includes SiCI4 (wherein SiCI4 can be named STC) and methane, the net reaction can be summarized as follows:

SiCl4 + CH4 = SiC + 4HCl

It should be noted that not every Si-bearing molecule and not every C-bearing molecule comes into contact with the deposition surfaces and undergoes the deposition reaction. Thus, it is preferred to pump in the feed gases at a higher rate than they depositing as SiC on the substrates. For example, if X moles of SiC are being deposited per square centimeter of deposition surface every hour, then it may be necessary to pump into the CVD reactor respectively SiC production reactor, in particular SiC PVT source material production reactor, AX moles of Si and AX moles of C every hour, where A is in the range between 8 and 10. The lower that A is the more efficient the conversion efficiency is from feed gas to deposited SiC. This efficiency is improved by optimizing the gas flow inside the CVD reactor respectively SiC production reactor, in particular SiC PVT source material production reactor, to maximize the contacting of the feed gas mixture with the deposition surfaces.

The surface of the base unit delimiting according to a further preferred embodiment of the present invention the reaction space and a top surface section of the surface of the bell jar delimiting the reaction space are spaced arranged in a first distance, wherein the top surface section of the surface of the bell jar is arranged in height direction in the farthest distance to surface of the base unit, wherein the first distance is the farthest distance, and wherein the SiC growth substrate or SiC growth substrates extend for a second distance into the height direction, wherein the second distance has less than 90% of the height of the first distance or the second distance has less than 85% of the height of the first distance or the second distance has less than 80% of the height of the first distance or the second distance has less than 75% of the height of the first distance or the second distance has less than 70% of the height of the first distance or wherein the SiC growth substrate or SiC growth substrates extend for a second distance into the height direction, wherein the first distance is up to 10% higher or up to 20% higher or up to 30% higher or up to 50% higher compared to the second distance. The first distance is according to a further preferred embodiment of the present invention more than or up to or exactly 100cm or preferably more than or up to or exactly 130cm or more than or up to or exactly 150cm or highly preferably more than or up to or exactly 170cm or more than or up to or exactly 200cm or more than or up to or exactly 250cm or more than or up to or exactly 300cm and/or an inner diameter of the reaction space is more than 50cm or more than or up to or exactly 70cm or more than or up to or exactly 100cm or preferably more than or up to or exactly 120cm or highly preferably more than or up to or exactly 150cm. This embodiment is beneficial since large SiC growth substrates can be used inside the SiC production reactor, thus the production efficiency can be increase.

The interface between the bell jar and the base unit comprises according to a further preferred embodiment of the present invention a sealing, wherein the sealing is configured to withstand pressure above 1bar, in particular above 2bar or above 5 bar and highly preferably between 1 and 20 bar. This embodiment is beneficial since a high feed medium density can be generated inside the process chamber causing a beneficial Si and C supply to the SiC growth substrate.

The bell jar, in particular the surface of the bell jar, is according to a further preferred embodiment of the present invention delimiting the reaction space, and/or the base unit, in particular the surface of the base plate delimiting the reaction space, is configured to withstand chemical treatments, in particular caustic soda, in particular for at least 30 seconds or for at least 60 seconds or for at least 5 min. This embodiment is beneficial since the bell jar can be cleaned respectively optimized for reuse.

The SiC growth substrate is according to a further preferred embodiment of the present invention configured to hold a SiC solid which has a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm. This embodiment is beneficial since large quantities of SiC material respectively PVT source material can be produced.

The reaction space volume allows according to a further preferred embodiment of the present invention the production of one SiC solid or multiple SiC solids at the same time, wherein the SiC solid has a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm or wherein multiple or all SiC solids have a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm. This embodiment is beneficial since large quantities of SiC material respectively PVT source material can be produced.

The SiC growth substrate is according to a further preferred embodiment of the present invention a preferably elongated single-piece substrate. The single piece substrate preferably comprises multiple sections having the same or similar diameter and/or the same or similar cross-sectional shape. The diameter, in particular diameter orthogonal to current flow direction, is at least along 50% of the length of the single-piece substrate and preferably at least along 70% of the length of the single-piece substrate and highly preferably at least along 90% of the length of the single-piece substrate and most preferably at least along 95% of the length of the single-piece substrate the same or similar, wherein similar means that the largest diameter is less than 200% of the smallest diameter and preferably the largest diameter is less than 150% of the smallest diameter and highly preferably the largest diameter is less than 110% of the smallest diameter and most preferably the largest diameter is less than 105% of the smallest diameter. The SiC growth substrate is according to a further preferred embodiment of the present invention a multi-piece substrate, wherein the multi-piece substrate comprises at least two elongated substrate parts, wherein the at least two elongated, in particular straight and/or curved, substrate parts are arranged in a row and preferably directly contacting each other, in particular via end faces. Preferably forms at least one substrate part, and preferably two or more than two substrate parts, in the direction of current flow a curve. A diameter orthogonal to the current flow direction of the substrate parts, in particular the straight and/or curved substrate parts, is preferably the same or the largest diameter is less than 200% of the smallest diameter or preferably less than 150% or highly preferably less than 110% and most preferably less than 105% of the smallest diameter. The SiC growth substrate comprises according to a further preferred embodiment of the present invention three or more than three substrate parts, wherein the substrate part contact surfaces between contacting substrate parts have the same or similar shape and/or the same or similar size, wherein a similar size means that the largest surface size of a substrate part contact surface is less than 200% of the surface size of the smallest substrate part contact surface or preferably the largest surface size of a substrate part contact surface is less than 150% of the surface size of the smallest substrate part contact surface or highly preferably the largest surface size of a substrate part contact surface is less than 110% of the surface size of the smallest substrate part contact surface or highly preferably the largest surface size of a substrate part contact surface is less than 105% of the surface size of the smallest substrate part contact surface.

The SiC growth substrate has according to a further preferred embodiment of the present invention a length, wherein the SiC growth substrate is coupled via a first end at least indirectly with one or at least one first metal electrode and via a second end at least indirectly with one or at least one second metal electrode, wherein the distance between the first end of the SiC growth substrate and the first metal electrode is less than 20% of the length of the SiC growth substrate and preferably less than 10% of the length of the SiC growth substrate and most preferably less than 5% of the length of the SiC growth substrate. Length of the SiC growth substrate is preferably defined as physical extension of the center of the SiC growth substrate in current flow direction.

It should further be noted that the total deposition surface area inside the CVD reactor respectively SiC production reactor, in particular SiC PVT source material production reactor, grows over time as more deposition accumulates on the SiC growth substrates and their circumference grows. The SiC growth substrates can be slim rods, which are preferably at least 1.0 cm in diameter and e.g. up to 250 cm in height. When they reach for example a diameter of 10 cm due to deposited SiC they have a total surface area proportionally 10 times larger than in the beginning. It is therefore necessary to also increase the total feed gas mixture flowrate to match this increase in volumetric deposition rate over the course of the deposition run.

A SiC growth substrate can accumulate a layer of deposition such that it can reach a total diameter of for example 20 cm. At this point the circumference is approximately 60 cm and if the perpendicular deposition rate is 1 mm per hour, the volumetric deposition rate is 6 cm3 per hour per every 1 cm of rod height. However, the average volumetric deposition rate throughout the run is actually closer to 3 cm3 per hour per cm because the slim rod starts at such a small diameter.

According to the present invention the average volumetric deposition rate is increased by utilizing a deposition substrate respectively SiC growth substrate with a large starting surface area. Whereas a slim rod of 1 cm diameter has a surface area of approximately 3 cm per cm of height a deposition substrate in the form of a thin 10 cm wide ribbon effectively as a starting surface area of 20 cm per cm of height, dramatically boosting the average volumetric deposition rate and allowing for the same amount of SiC to be deposited in a much shorter run time. Accordingly, the CVD reactor respectively SiC production reactor, in particular SiC PVT source material production reactor, is able to perform more runs per year. As a consequence, fewer CVD reactors respectively SiC production reactors, in particular SiC PVT source material production reactors, are required to manufacture the same overall tonnage of SiC. Therefore, it is a preferred embodiment of the present invention to use deposition substrates with high starting surface areas.

The SiC growth substrate has according to a further preferred embodiment of the present invention an average perimeter of at least 5cm and preferably of at least 7 cm and highly preferably of at least 10 cm around a cross-sectional area orthogonal to the length direction of the SiC growth substrate or multiple SiC growth substrates have an average perimeter per SiC growth substrate of at least 5cm and preferably of at least 7 cm and highly preferably of at least 10 cm around a cross-sectional area orthogonal to the length direction of the respective SiC growth substrate. The SiC growth substrate preferably has an average perimeter of up to 25cm or preferably of up to 50cm or highly preferably of up to 100cm. The SiC growth substrate highly preferably has an average perimeter between 5cm and 100cm, preferably between 6cm and 50cm and highly preferably between 7cm and 25cm and most preferably between 7,5cm and 15cm or wherein SiC growth substrate has an average perimeter between 5cm and 20cm preferably between 5cm and 15cm and highly preferably between 5cm and 12cm. This embodiment is beneficial since due to a large perimeter a high volumetric growth can be generated. Thus, the same amount of SiC can be produced much faster.

The SiC growth substrate comprises or consists according to a further preferred embodiment of the present invention of SiC or C, in particular graphite, or wherein multiple SiC growth substrates comprise or consist of SiC or C, in particular graphite. Thus, graphite and carbon-carbon composite are preferred materials for use as deposition substrates for SiC. They can be easily separated from the SiC by mechanical means and by combustion and residual C on the SiC in the ppm levels is not detrimental to the performance of the SiC as a source material for PVT growth of monocrystalline SiC. However, it is also possible to remove the residual C from the SiC surface.

The shape of the cross-sectional area orthogonal or perpendicular to the length direction of the SiC growth substrate differs according to a further preferred embodiment of the present invention at least in sections and preferably along more than 50% of the length of the SiC growth substrate and highly preferably along more than 90% of the length of the SiC growth substrate from a circular shape.

A ratio (U/A) between the cross-sectional area (A) and the perimeter (U) around the cross-sectional area is according to a further preferred embodiment of the present invention higher than 1.2 1/cm and preferably higher than 1.5 1/cm and highly preferably higher than 2 1/cm and most preferably higher than 2.5 1/cm. This embodiment is beneficial since a high ratio (U/A) enables higher volumetric growth.

The above-mentioned object is also solved by a method according to claim 20. The method according to claim 20 is a method for growing SiC, in particular for growing SiC on a SiC growth substrate, in particular on a SiC growth substrate according to claims 1 to 17. Said method preferably comprises the steps: Increasing current flow through the SiC growth substrate over time to keep a temperature of a growth face in a defined temperature range, Depositing SiC on the SiC growth substrate and thereby forming a crust of SiC, Growing the crust of SiC to a thickness of more than 1 cm, in particular of more than 3cm or more than 5cm or highly preferably more than 10cm, Preventing cracking of the defined volume section of the SiC growth substrate during the growth step by means of the physical structure of the main body.

According to a further preferred embodiment of the before mentioned method a step of providing a source medium inside a process chamber is provided, wherein the step of providing the source medium inside the process chamber, comprises introducing at least a first feed-medium, in particular a first source gas, into the process chamber, said first feed medium comprises Si, wherein the first-feed medium has a purity which excludes at least 99.9999% (ppm wt) of the substances B, Al, P, Ti, V, Fe, Ni, and introducing at least a second feed-medium, in particular a second source gas, into the process chamber, the second feed medium comprises C, in particular natural gas, Methane, Ethane, Propane, Butane and/or Acetylene, wherein the second-feed medium has a purity which excludes at least 99.9999% (ppm wt) of the substances B, Al, P, Ti, V, Fe, Ni, and introducing a carrier gas, wherein the carrier gas has a purity which excludes at least 99.9999% (ppm wt) of the substances B, Al, P, Ti, V, Fe, Ni, or introducing one feed-medium in particular a source gas, into the process chamber, said feed medium comprises Si and C, in particular SiCl3(CH3), wherein the feed medium has a purity which excludes at least 99.9999% (ppm wt) of the substances B, Al, P, Ti, V, Fe, Ni, and introducing a carrier gas, wherein the carrier gas has a purity which excludes at least 99.9999% (ppm wt) of the substances B, Al, P, Ti, V, Fe, Ni.

Further advantages, objectives and features of the present invention are explained with reference to the following description of accompanying drawings, in which the device(s) according to the invention are shown by way of example. Components or elements of the device or reactor or system or SiC growth substrate according to the invention, which at least substantially correspond in the figures with respect to their function, can be marked with the same reference signs, whereby these components or elements do not have to be numbered or explained in all figures.

Individual or all representations of the figures described in the following are preferably to be regarded as construction drawings, i.e. the dimensions, proportions, functional relationships and/or arrangements resulting from the figure or figures preferably correspond exactly or preferably substantially to those of the device according to the invention or the product according to the invention or the method according to the invention.

Therein show:
- Fig. 1: schematically a first example of a CVD reactor according to the present invention,
- Fig. 2: schematically a second example of a CVD reactor according to the present
- invention, Fig. 3: schematically a third example of a CVD reactor according to the present invention,
- Fig. 4a-g: schematically examples of SiC growth substrates, in particular of the CVD reactors of Fig. 1, 2 or 3,
- Fig. 5a-e: schematically examples of SiC growth substrates, in particular of the CVD reactors of Fig. 1, 2 or 3,
- Fig. 6a/b: schematically a blade shaped example of a SiC growth substrates, in particular of the CVD reactors of Fig. 1, 2 or 3,
- Fig. 6c/d: schematically a tube-shaped example of a SiC growth substrates, in particular of the CVD reactors of Fig. 1, 2 or 3,
- Fig. 7a-c: schematically examples of growth substrates having a crack-free area and
- Fig. 7d: schematically an example of a cross-sectional view of a rod-shaped growth substrate.

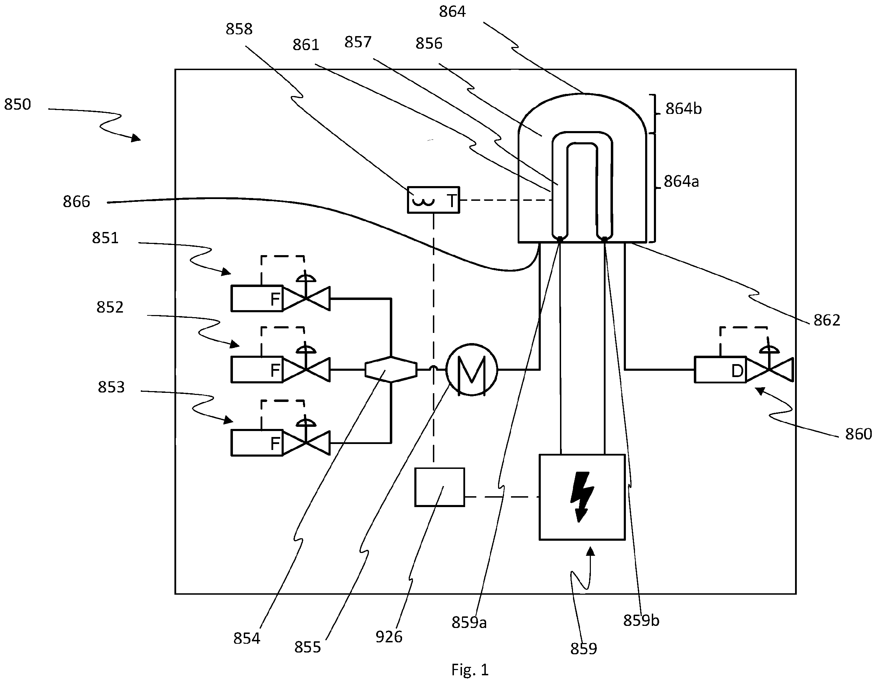

Fig. 1 shows an example of a manufacturing device 850 for producing SiC material, in particular 3C-SiC material. This device 850 comprises a first feeding device 851, a second feeding device 852 and a third feeding device 853. The first feed device 851 is preferably designed as a first mass flow controller, in particular for controlling the mass flow of a first source fluid, in particular a first source liquid or a first source gas, wherein the first source fluid preferably comprises Si, in particular e.g. silanes/chlorosilanes of the general composition SiH4-mClm or organochlorosilanes of the general composition SiR4-mClm (where R = hydrogen, hydrocarbon or chlorohydrocarbon). The second feed device 852 is preferably designed as a second mass flow controller, in particular for controlling the mass flow of a second source fluid, in particular a second source liquid or a second source gas, wherein the second source fluid preferably comprises C, e.g. hydrocarbons or chlorohydrocarbons, preferably with a boiling point < 100 °C, particularly preferably methane. The third feed device 853 is preferably designed as a third mass flow controller, in particular for controlling the mass flow of a carrier fluid, in particular a carrier gas, wherein the carrier fluid or carrier gas preferably comprises H or H2, respectively, or mixtures of hydrogen and inert gases.

The reference sign 854 indicates a mixing device or a mixer by which the source fluids and/or the carrier fluid can be mixed with one another, in particular in predetermined ratios. The reference sign 855 indicates an evaporator device or an evaporator by which the fluid mixture which can be supplied from the mixing device 854 to the evaporator device 855 can be evaporated.

The evaporated fluid mixture is then fed to a process chamber 856 or a separator vessel, which is designed as a pressure vessel. At least one deposition element 857 and preferably several deposition elements 857 are arranged in the process chamber 856, wherein Si and C are deposited from the vaporized fluid mixture at the deposition element 857 and SiC is formed.

The reference sign 858 indicates a temperature measuring device, which is preferably provided for determining the surface temperature of the deposition element 857 and is preferably connected to a control device (not shown) by data and/or signal technology.

The reference sign 859 indicates an energy source, in particular for introducing electrical energy into the separating element 857 for heating the separating element. The energy source 859 is thereby preferably also connected to the control device in terms of signals and/or data. Preferably, the control device controls the energy supply, in particular power supply, through the deposition element 857 depending on the measurement signals and/or measurement data output by the temperature measurement device 858.

Furthermore, a pressure holding device is indicated by the reference sign 860. The pressure holding device 860 can preferably be implemented by a pressure-regulated valve or the working pressure of a downstream exhaust gas treatment system.

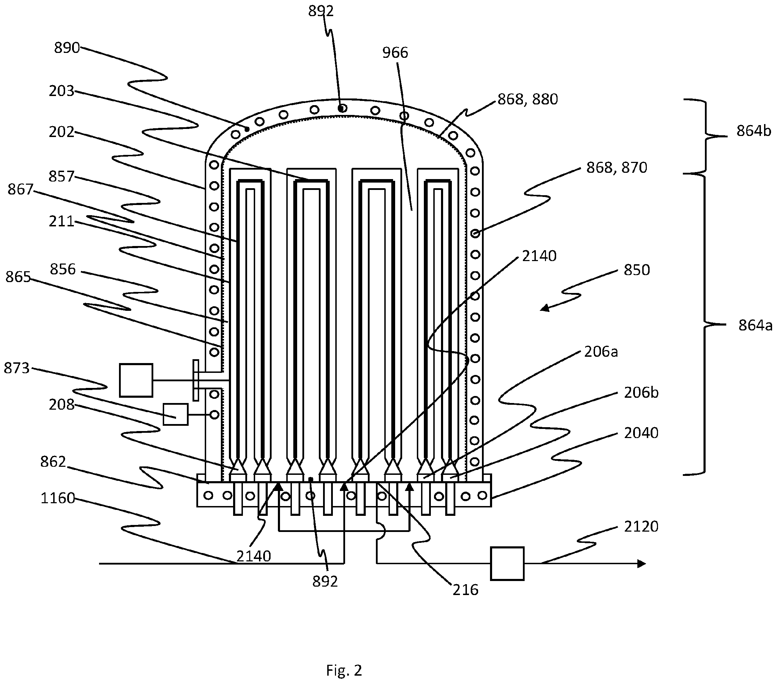

Fig. 2 shows the CVD unit respectively CVD reactor respectively SiC production reactor, in particular SiC PVT source material production reactor, 850 of one preferred embodiment of the present invention. The CVD unit respectively CVD reactor respectively SiC production reactor, in particular SiC PVT source material production reactor, 850 preferably comprises a fluid, in particular oil or water, cooled steel upper housing 202 or bell jar which seals, in particular by means of one or multiple gaskets, against a preferably fluid, in particular oil or water, cooled lower housing 2040 or base plate creating a deposition chamber respectively process chamber 856 which can be pressurized preferably to at least 6 bar, in particular to a pressure between 2 bar and 15bar. The feed gas mixture 1160 preferably enters the deposition chamber respectively process chamber 856 through a plurality of feed gas inlets 2140 and the vent gas 2120 preferably exists through the gas outlet unit respectively vent gas outlet 216. Inside the deposition chamber preferably a plurality of resistively self-heated deposition substrates respectively SiC growth substrate 857 preferably made of graphite or silicon carbide or metal are provided which are connected to chucks 208 which are preferably made of graphite. The chucks 208 are in turn connected to water cooled electrodes 206 preferably made of copper which pass through the baseplate so that they can be connected to an external source of electrical power. The deposition substrates respectively SiC growth substrate 857 are preferably arranged as pairs via cross members 203 to complete an electrical circuit for resistive heating.

The purpose of the chucks 208 is to create a temperature gradient between the electrodes 206 which are in a temperature range of preferably between 850 and 400°C and the deposition substrate respectively SiC growth substrate 857 which is preferably in temperature range of 1300 and 1600°C. The chuck 208 preferably achieves this by having a continuously reducing current flow cross section area resulting in higher and higher resistive heating. Thus, the chuck 208 preferably has a conical shape. In this manner the starting point for the deposition of CVD SiC crust 211 can be controlled preferably to a point for example midway up the chuck 208 such that the final deposition substrate respectively SiC growth substrate 857 with the deposited CVD SiC crust 211 has a structurally strong connection at the bottom and will not break or fall over.

The plurality of feed gas inlets 2140 is preferably designed to create a turbulent gas flow pattern inside the deposition chamber respectively process chamber 856 so as to maximize the contact of fresh feed gas with the surface of the CVD SiC crust 211 being deposited on the deposition substrates respectively SiC growth substrate 857. Additionally, or alternatively it is possible to provide a gas turbulence generating apparatus, in particular inside the process chamber. The gas turbulence generating apparatus can be a ventilator or circulator pump. This ensures that a minimum excess of feed gas mixture 1160 is used to produce a given quantity of CVD SiC crust 211. The vent gas 2120 which contains unreacted feed gas mixture as well as altered Si-bearing gas and HCI gas is forced out of the deposition chamber respectively process chamber 856 through the vent gas outlet by the incoming feed gas mixture 1160.

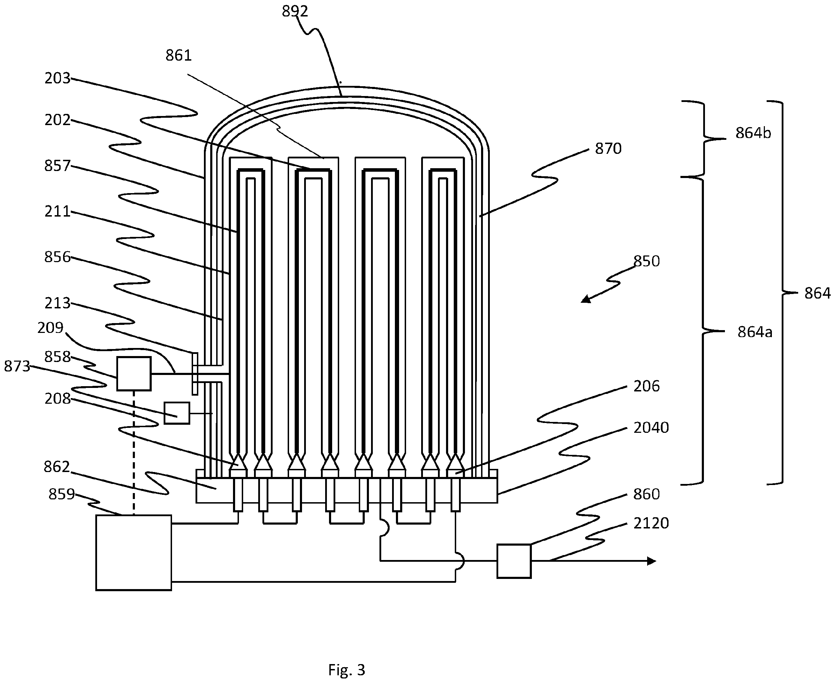

Fig. 3 shows examples of the temperature and pressure control methods for the CVD unit. A temperature control unit respectively temperature measuring device 858 is positioned such that to measure the temperature of the CVD SiC crust 211 along the temperature measurement path 209 preferably through the sight glass 213 which is preferably fluid, in particular oil or water, cooled. The temperature control unit respectively temperature measuring device 858 preferably measures the temperature of the surface of the CVD SiC crust and sends a signal to the power supply unit respectively energy source 859 to increase or decrease power to the deposition substrates respectively SiC growth substrate 857 depending on whether the temperature is below or above the desired temperature respectively. The power supply unit respectively energy source 859 is wired to the fluid, in particular oil or water-cooled electrodes 206 and adjusts voltage and/or current to the fluid, in particular oil or water, cooled electrodes 206 accordingly. The deposition substrates respectively SiC growth substrate 857 are wired in pairs and have connecting cross members at the top so as to form a complete electrical circuit for the flow of current.

Pressure inside the deposition chamber respectively process chamber 856 is adjusted by means of a pressure control unit respectively pressure maintaining device 860 which senses the pressure and decreases or increases the flowrate of vent gas 2120 from the deposition chamber respectively process chamber 856.

Thus, as shown in fig. 2 and 3 the SiC production reactor 850 according to the present invention preferably comprises at least a process chamber 856, wherein the process chamber 856 is at least surrounded by a base plate 862, a side wall section 864a and a top wall section 864b. the reactor 850 preferably comprises a gas inlet unit 866 for feeding one feed-medium or multiple feed-mediums into a reaction space of the process chamber 856 for generating a source medium inside the process chamber 856. The base plate 862 preferably comprises at least one cooling element 868, 870, 880, in particular a base cooling element, for preventing heating the base plate 862 above a defined temperature and/or wherein the side wall section 864a preferably comprises at least one cooling element 868, 870, 880, in particular a bell jar cooling element, for preventing heating the side wall section 864a above a defined temperature and/or wherein the top wall section 864b preferably comprises at least one cooling element 868, 870, 880, in particular a bell jar cooling element, for preventing heating the top wall section 864b above a defined temperature. The cooling element 868 can be an active cooling element 870, thus the base plate 862 and/or side wall section 864a and/or top wall section 864b preferably comprises a cooling fluid guide unit 872, 874, 876 for guiding a cooling fluid, wherein the cooling fluid guide unit 872, 874, 876 is configured limit heating of the base plate 862 and/or side wall section 864a and/or top wall section 864b to a temperature below 1000°C. It is additionally possible that a base plate and/or side wall section and/or top wall section sensor unit 890 is provided to detect the temperature of the base plate 862 and/or side wall section 864a and/or top wall section 864b and to output a temperature signal or temperature data. The at least one base plate and/or side wall section and/or top wall section sensor unit 890 can be arranged as part of a surface or on a surface inside the process chamber, in particular on a surface of the base plate 862 or the side wall section 864a or the top wall section 864b. Additionally or alternatively it is possible to provide one or more base plate and/or side wall section and/or top wall section sensor unit/s 890 inside the base plate 862 or inside the side wall section 864a or inside the top wall section 864b. Additionally or alternatively it is possible to provide a cooling fluid temperature sensor 820 to detect the temperature of the cooling fluid guided through the cooling fluid guide unit 870. A fluid forwarding unit 873 can be provided for forwarding the cooling fluid through the fluid guide unit 872, 874, 876, wherein the fluid forwarding unit 873 is preferably configured to be operated in dependency of the temperature signal or temperature data provided by the base plate and/or side wall section and/or top wall section sensor unit 890 and/or cooling fluid temperature sensor 892. The cooling fluid can be oil or preferably water, wherein the water preferably comprises at least one additive, in particular corrosion inhibiter/s and/or antifouling agent/s (biocides).

Additionally, or alternatively the cooling element 868 is a passive cooling element 880. Thus, the cooling element 868 can be at least partially formed by a polished steel surface 865 of the base plate 862, the side wall section 864a and/or the top wall section 864b, preferably by a polished steel surface 865 of the base plate 862, the side wall section 864a and the top wall section 864b. The passive cooling element 868 can be a coating 867, wherein the coating 867 is preferably formed above the polished steel surface 865 and wherein the coating 867 is configured to reflect heat. The coating 867 can be a metal coating or a comprises metal, in particular silver or gold or chrome, or can be an alloy coating, in particular a CuNi alloy. The emissivity of the polished steel surface 865 and/or of the coating 867 is 0.3, in particular below 0.1 and highly preferably below 0.03.

The base plate 862 can comprise at least one active cooling element 870 and one passive cooling element 880 for preventing heating the base plate 862 above a defined temperature and/or the side wall section 864a can comprise at least one active cooling element 870 and one passive cooling element 880 for preventing heating the side wall section 864a above a defined temperature and/or the top wall section 864b can comprises at least one active cooling element 870 and one passive cooling element 880 for preventing heating the top wall section 864b above a defined temperature.

The side wall section 864a and the top wall section 864b are preferably formed by a bell jar 864, wherein the bell jar 864. The bell jar 864 is preferably movable with respect to the base plate 862.

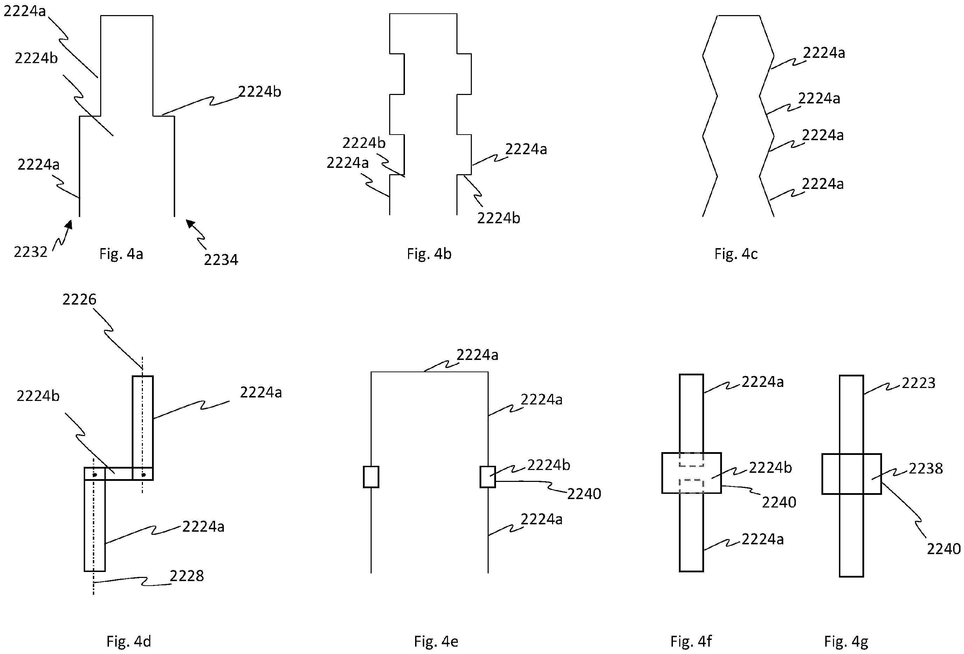

Fig. 4a shows a first multi-piece SiC growth substrate 857. Thus, it is possible to have at least or exactly two pieces 2224a of a first type defining the length of the SiC growth substrate 857.

The SiC growth substrate 857 is preferably formed in a "U-shape". Such a "U-shape" is preferably characterized by a first leg 2232 and a second leg 2234 and a connecting part 2236 for connecting the first leg 2232 and the second leg 2234. The first leg 2232 is preferably formed negative to the second leg 2234. However, it is also possible to have the first leg 2232 formed by main pieces of a first type and the second leg by main pieces of a second type. It is additionally or alternatively possible that the first leg 2232 comprises a first number of pieces 2224a and/or 2224b and that the second leg 2234 comprises a second number of pieces 2224a and/or 2224b. The same applies for the other multi piece SiC substrates 857 disclosed herein.

Fig. 4b shows a further example of a further multi-piece SiC growth substrate 857. Thus, contrary to the SiC growth substrate 857 of Fig. 4a the present SiC growth substrate 857 comprises a first leg 2232 and a second leg 2234, wherein each leg 2232/2234 comprises more than two pieces 2224a of a first type and more than two pieces 2224b of a second type.

Fig. 4c shows a further example of a further multi-piece SiC growth substrate 857. According to this example the individual pieces 2224a can be arranged in angles different than 90° or 180°.

Fig. 4d shows schematically that two pieces 2224a of a first type preferably can be arranged in such a manner that a central axis 2226 of one piece and a central axis 2228 of the other piece are arranged in a distance to each other, in particular in a distance of ore than 8cm or more than 12cm or more than 15cm. The central axes 2226, 2228 are preferably arranged in parallel to each other.

Fig. 4e shows a further example of a multi-piece SiC growth substrate 857. The pieces 2224a of the first type can be coupled via pieces 2224b of a second type, wherein the diameter of the pieces 2224b of the second type is preferably so large that at least one section of the surface surrounding the central axis of the pieces 2224b of the second type surrounds the central axis in a distance of 0,5 × diameter. This embodiment is beneficial since depositing of SiC is prevented or limited to avoid forming of a SiC crust on the circumferential surface of the connecting piece 2224b.

Fig. 4f schematically shows an example of how two pieces 2224a can be coupled by a large diameter connecting piece 2224b.

Fig. 4g schematically shows an example of a long none-SiC-substrate 2223, e.g. graphite, wherein a surface temperature lowering element 2238 is coupled to the long-none-SiC-substrate 2223. The long none-SiC-substrate 2223 preferably has a length of more than 25cm and particular preferably of more than 50cm and highly preferably of 75cm and most preferably of more than 100cm or a length between 50cm and 200cm, in particular between 60cm and 150cm. The diameter of the surface temperature lowering element 2238 is preferably larger than 1.3 × diameter of long-none-SiC-substrate 2223 and preferably larger than 1.5 × diameter of long-none-SiC-substrate 2223 and highly preferably larger than 2 × diameter of long-none-SiC-substrate 2223 and most preferably larger than 2.5 × diameter of long-none-SiC-substrate 2223. The surface temperature lowering element 2238 is preferably made of graphite or preferably comprises graphite. The surface temperature lowering element 2238 can be a one-piece element or can be made of multiple pieces, in particular two or more than two pieces. The surface temperature lowering element 2238 can be attached to the long none-SiC-substrate 2223 by means of an adhesive connection and/or force closure and/or form closure.

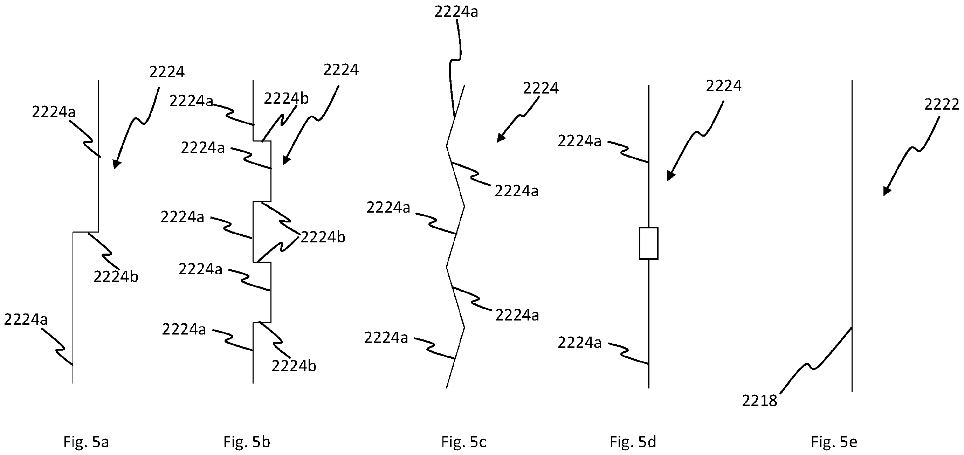

Fig. 5a-d show that the SiC growth substrates 857 shown in fig. 4a, b, c and e do not have to be shaped in the form of an "U" since it is also possible to shape them in different forms. One further example if a preferred form is a "I" form. According to the "I" the electrical connections are arranged on opposing sides of the reaction space 966. Furthermore, the SiC growth substrates 857 can be formed in "N", "M" or "W" shape, wherein preferably only two electrical connections are provided per SiC growth substrate, in particular at the end of the respective substrate (in analog manner to the "U" shape).

Fig. 5e shows a SiC growth substrate 857 which is a single piece 2222. The single piece SiC growth substrate 857 can be solid or hollow. Thus, the single piece SiC growth substrate 857 can be formed as a solid rod 2218 or tube. The single piece SiC growth substrate 857 can be made of SiC or graphite.

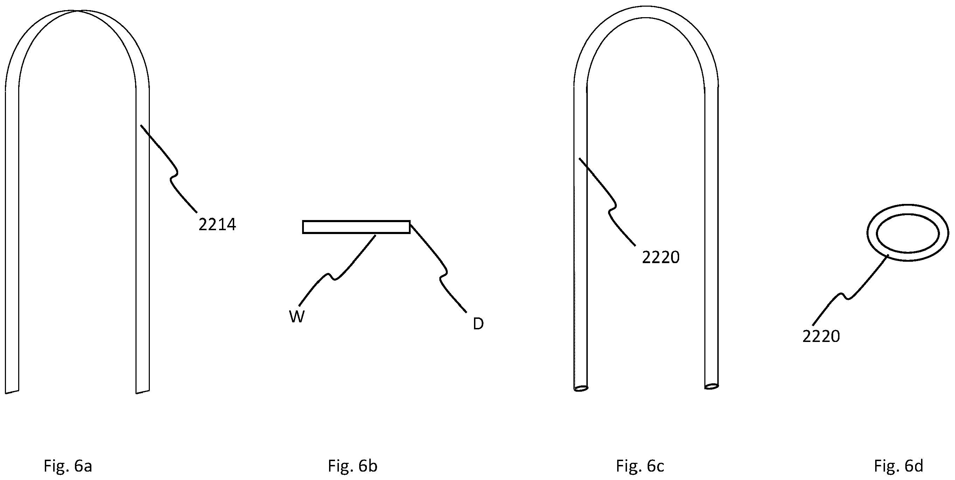

Fig. 6a schematically shows an example of a blade or band like 2214 SiC growth substrate 857. Said SiC growth substrate 857 can be a single piece or formed by multiple pieces. The SiC growth substrate 857 preferably comprises graphite respectively carbon fibers. Highly preferably the SiC growth substrate 857 is made of one or multiple carbon fiber composite elements 2242.

Fig. 6b schematically shows a cross-sectional view of the blade or band like 2214 SiC growth substrate 857 of Fig. 6a. It can be understood from fig. 6b that width W is multiple times larger compared to depth D. Depth D is preferably smaller than 0,5cm, in particular smaller than 0,2cm or is between 0,01cm and 0,15cm. Width W is preferably above 3cm and highly preferably above 10cm and most preferably above 15cm. Such a W/D ratio is highly beneficial since a significant amount of SiC can be deposited immediately after a start of a production run.

Fig. 6c schematically shows an example of a tube like 2220 SiC growth substrate 857. Said SiC growth substrate 857 can be a single piece or formed by multiple pieces. The SiC growth substrate 857 preferably comprises graphite respectively carbon fibers. Highly preferably the SiC growth substrate 857 is made of one or multiple carbon fiber composite elements 2242.

Fig. 6d schematically shows a cross-sectional view of the blade or band like 2220 SiC growth substrate 857 of Fig. 6c. It can be understood from fig. 6d that a diameter of the tube is preferably multiple times, in particular more than 2,5 times or preferably more than 3 times or highly preferably more than 4 times and most preferably more than 5 times, larger compared to the thickness of the tube wall.

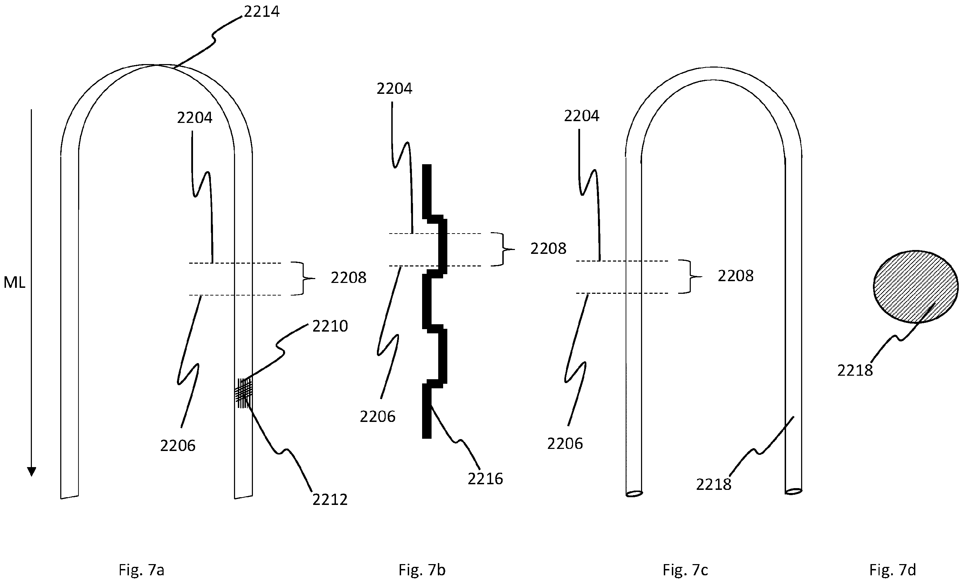

Fig. 7a-c schematically show different examples of SiC growth substrates 857 according to the present invention. In each of said figures a region is defined in which crack-free material is formed. That region is formed between a first plane 2204 and a second plane 2206, wherein the first plane 2204 and the second plane 2206 are parallel to each other and in a distance 2208 to each other. The distance 2208 is preferably lager than 1cm and preferably larger than 2cm and highly preferably larger than 5cm and most preferably larger than 10cm or the distance is between 1,5cm and 50cm, in particular between 2cm and 25cm or between 2,2cm and 15cm.

Fig. 7a shows carbon fibers 2210, wherein said carbon fibers 2210 are preferably arranged in different directions and thereby form a carbon fiber composite material 2212.

Fig. 7d schematically shows an example of a cross-sectional view through rod shaped 2218 SiC growth substrate 857 of fig. 7c.

Thus, the present invention refers to a SiC growth substrate 857 for growing SiC in a CVD reactor 850. Said SiC growth substrate 857 preferably comprises at least a main body 2200, a first power connection 859a and a second power connection 859b, wherein the main body 2200 has a main body length ML, wherein the main body length ML extends between the first power connection 859a and the second power connection 859b. The first power connection 859a is preferably configured to conduct power into the main body 2200 for heating the main body 2200 and wherein the second power connection 859b is preferably configured to conduct electric power conducted via the first power connection 859a into the main body 2200 out of the main body 2200. The main body 2200 forms a physical structure, wherein the physical structure preferably forms a deposition surface 861 for deposition of SiC for growing a SiC crust 211. The physical structure is preferably configured to resist forces generated during growth of the SiC crust 211 having a minimal thickness of at least 1cm. Alternatively the physical structure is preferably configured to prevent generating of forces during growth of the SiC crust 211 having a minimal thickness of at least 1cm. Both (resisting/preventing) preferably allows or causes preventing of cracking of the physical structure due to the generated forces at least in a defined volume section of the physical structure. The defined volume section 2202 is preferably formed between a first plane 2204 and a second plane 2206, wherein the first plane 2204 is highly preferably perpendicular to the main body length ML and wherein the second plane 2206 is perpendicular to the main body length ML or perpendicular to a main extension direction of a connecting part 2236. The distance 2208 between the first plane 2204 and the second plane 2206 is preferably at least 5% of the main body length ML.

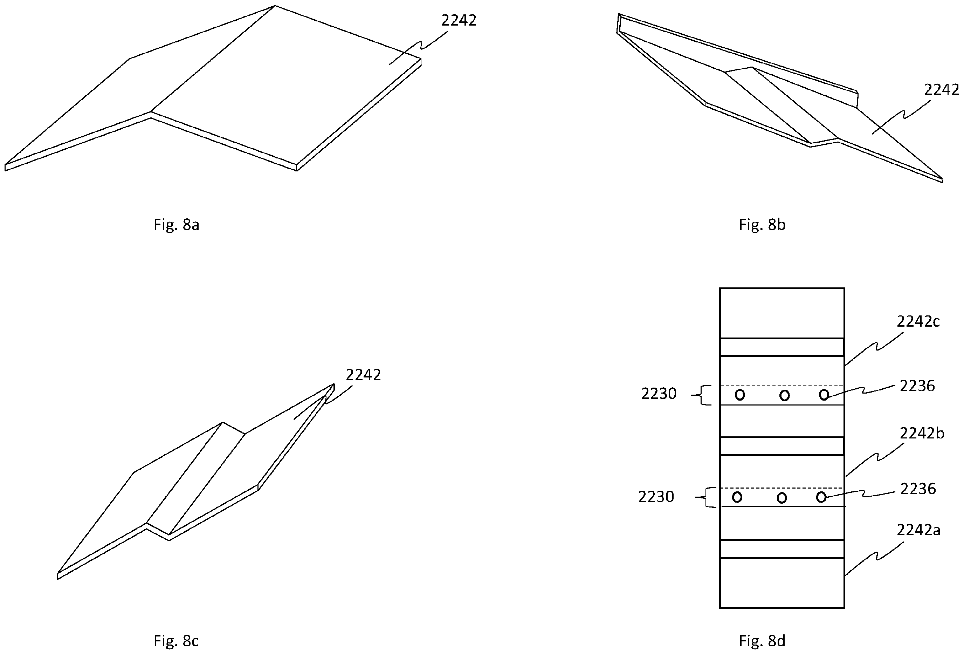

Fig. 8a-8c schematically show examples of carbon fiber composite elements 2242 for forming a SiC growth substrate 857. The carbon fiber composite element 2242 are preferably very thin or comprise very thin sections, in particular less than 1cm thick or less than 0,5cm thick or less than 0,2cm or less than 0,1cm. The carbon fiber composite elements 2242 preferably have a shape, in particular a bend or sharp bend, that gives the carbon fiber composite elements 2242 a mechanical stability for allowing upright positioning.

Fig. 8d schematically shows an example according to which a first carbon fiber composite element 2242a, a second carbon fiber composite element 2242b and a third carbon fiber composite element 2242c are coupled to each other to form a SiC growth substrate 857. In the present example the carbon fiber composite elements 2242a/b and carbon fiber composite element 2242b/c form overlapping areas 2230 for coupling the respective carbon fiber composite elements 2242a/b or 2242b/c. In the present example coupling is carried out be means of coupling elements 2230, wherein said coupling elements 2230 can be e.g. screws or pins or studs. The coupling elements 2230 are preferably made of graphite. However, it is additionally or alternatively possible to couple the carbon fiber composite elements 2242a/b and/or carbon fiber composite elements 2242b/c by means of a force closure and/or form closure and/or adhesive closure. In the present example the carbon fiber composite elements 2242a/b and carbon fiber composite elements 2242b/c are having the same or similar shapes, however it is possible that some or all of the carbon fiber composite elements can have different shapes respectively a shape different from the shape of at least one further carbon fiber composite element.

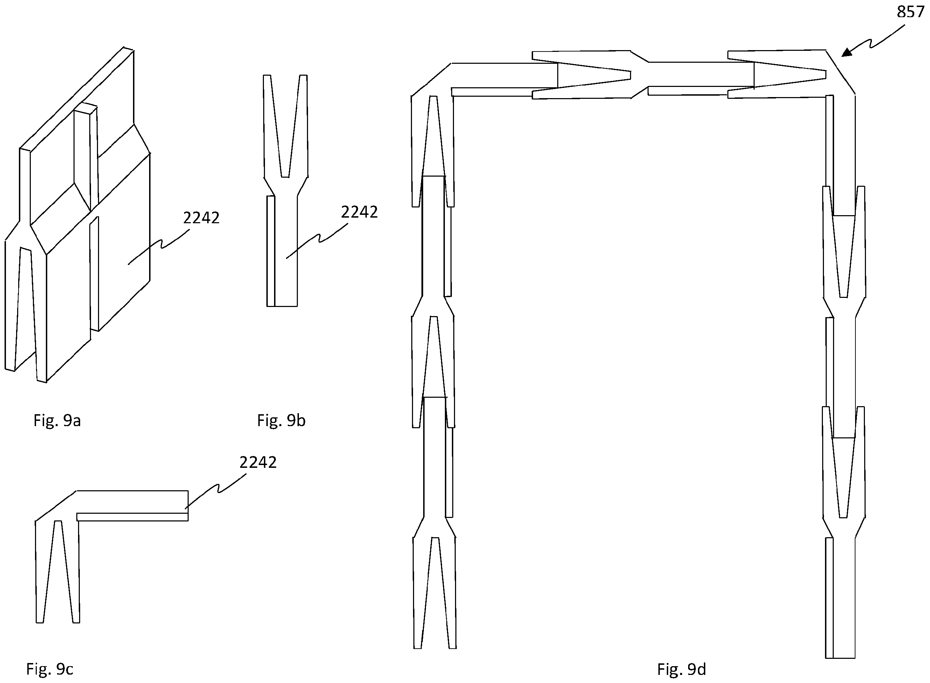

Fig. 9a-c schematically show further examples of carbon fiber composite elements 2242. Said carbon fiber composite elements 2242 can be manufactured to allow form and/or force closure.

Fig. 9d schematically shows an example of a further Sic growth substrate 857 formed by multiple carbon fiber composite elements 2242.

**List of reference numbers**

| | | | |
|---|---|---|---|
| | | 858 | temperature measuring device or temperature control unit |
| 202 | Upper housing | 859 | Energy source, especially power supply |
| 203 | Cross member | 859a | first power connection |
| 206a | first electrode | 859b | second power connection |
| 206b | second electrode | 860 | Pressure maintaining device or pressure control unit |
| 208 | Chuck | | |
| 209 | Temperature measurement path | 861 | outer surface of SiC growth substrate or SiC growth surface |
| 211 | SiC crust | | |
| 213 | Sight glass | 862 | base plate |
| 850 | manufacturing device or CVD unit or CVD reactor respectively SiC production reactor, in particular SiC PVT source material production reactor | 864 | bell jar |
| | | 864a | side wall section |
| | | 864b | top wall section |
| | | 865 | metal surface |
| 851 | first feeding device respectively first feed-medium source | 866 | gas inlet unit |
| | | 867 | reflective coating |
| 852 | second feeding device respectively | 868 | cooling element |
| | second feed-medium source | 870 | active cooling element |
| 853 | third feeding device respectively third feed-medium source respectively carrier gas feed-medium source | 873 | fluid forwarding unit |
| | | 892 | cooling fluid temperature sensor |
| | | 966 | reaction space |
| 854 | mixing device | | |
| | | 1160 | Feed gas mixture |
| 855 | evaporator device | | |
| | | 2040 | Lower housing |
| 856 | process chamber | 2120 | Vent gas |
| 857 | SiC growth substrate | 2140 | Feed gas inlet |
| 2200 | main body | 2230 | overlap area |
| 2202 | defined volume section | 2232 | first leg |
| 2204 | first plane | 2234 | second leg |
| 2206 | second plane | 2236 | connecting part |
| 2208 | distance | 2238 | surface temperature lowering |
| 2210 | carbon fibers | | element |
| 2212 | carbon fiber composite material | 2240 | lateral surface / circumferential surface |
| 2214 | band like shape / blade like shape | | |
| | | 2242 | carbon fiber composite element |
| 2216 | graphite element | | |
| | | 2242a | first carbon fiber composite element |
| 2218 | solid SiC rod | 2242b | second carbon fiber composite |
| 2220 | tubular shape | | element |
| 2222 | single piece | 2242c | third carbon fiber composite element |
| 2223 | long-non-SiC-substrate | 2244 | coupling element |
| 2224 | multi piece | | |
| 2224a | first piece / main piece | D | Depth |
| 2224b | second piece / connecting piece | ML | Main body length |
| 2226 | first central axis | W | Width |
| 2228 | second central axis | | |

## Claims

1. SiC growth substrate (857) for growing SiC in a CVD reactor (850),
at least comprising
a main body (2200),
a first power connection (859a) and
a second power connection (859b),
wherein the main body (2200) has a main body length (ML), wherein the main body length (ML) extends between the first power connection (859a) and the second power connection (859b),
wherein the first power connection (859a) is configured to conduct power into the main body (2200) for heating the main body (2200) and wherein the second power connection (859b) is configured to conduct electric power conducted via the first power connection (859a) into the main body (2200) out of the main body (2200),
wherein the main body (2200) forms a physical structure,
wherein the physical structure forms a deposition surface (861) for deposition of SiC for growing a SiC crust (211),
wherein the physical structure is configured
to resist forces generated during growth of the SiC crust (211) having a minimal thickness of at least 1cm
or
to prevent generating of forces during growth of the SiC crust (211) having a minimal thickness of at least 1cm
for preventing cracking of the physical structure due to the generated forces at least in a defined volume section of the physical structure,
wherein the defined volume section (2202) is formed between a first plane (2204) and a second plane (2206), wherein the first plane (2204) is perpendicular to the main body length (ML) and wherein the second plane (2206) is perpendicular to the main body length (ML), wherein the distance (2208) between the first plane (2204) and the second plane (2206) is at least 5% of the main body length (ML).

2. SiC growth substrate according to claim 1,
**characterized in that**
the physical structure is configured to resist forces generated during growth of the SiC crust (211) having a minimal thickness of at least 3cm for preventing cracking of the physical structure due to the generated forces.

3. SiC growth substrate according to claim 1,
**characterized in that**
the physical structure is configured to resist forces generated during growth of the SiC crust (211) having a minimal thickness of at least 5cm for preventing cracking of the physical structure due to the generated forces.

4. SiC growth substrate according to claim 1 or 2 or 3,
**characterized in that**
the physical structure comprises carbon fibers (2210).

5. SiC growth substrate according to claim 4,
**characterized in that**
the physical structure is formed by a carbon fiber composite material (2212).

6. SiC growth substrate according to claim 5,
**characterized in that**
the physical structure formed by the carbon fiber composite material (2212) has a tensile strength above 50 MPa and/or a flexural strength above 50 MPa.

7. SiC growth substrate according to claim 5 or 6,
**characterized in that**
the physical structure has at least in sections and preferably along more than 50% of the length (ML) of the physical structure and most preferably entirely a band-like shape (2214), wherein the band like shape (2214) forms a cross-section having a width (W) and a depth (D), wherein width (W) is at least 2 times depth (D) and preferably at least 3 times and highly preferably at least 5 times and most preferably up to or exactly or more than 10 times.

8. SiC growth substrate according to claim 7,
**characterized in that**
width (W) is smaller than 1.5 cm and depth (D) is larger than 3.0 cm.

9. SiC growth substrate according to claim 5 or 6,
**characterized in that**
the physical structure has at least in sections and preferably along more than 50% of the length of the physical structure and most preferably entirely a tubular shape (2220), wherein the tubular shape (2220) forms a cross-section having an average wall thickness respectively depth (D) of less than 5cm and preferably of less than 2cm and particular preferably of less than 1cm and most preferably of less than 0,5cm, in particular less than 3mm or less than 2mm or less than 1mm.

10. SiC growth substrate according to claim 1 or 2 or 3,
**characterized in that**
the physical structure is formed by a SiC element, in particular rod (2218), in particular a polycrystalline SiC rod (2218).

11. SiC growth substrate according to claim 10,
**characterized in that**
the SiC element (2218) comprises more than 75% [mass] and preferably more than 95% [mass] and highly preferably more than 99% [mass] SiC.

12. SiC growth substrate according to claims 4 to 11,
**characterized in that**
the physical structure is a single piece (2222).

13. SiC growth substrate according to claims 4 to 11,
**characterized in that**
the physical structure is formed by multiple pieces (2224), wherein the multiple pieces are coupled to each other by means of a form closure and/or a force closure.

14. SiC growth substrate according to claims 1 to 3,
**characterized in that**
the physical structure is formed by multiple pieces (2224a, 2224b), wherein at least some and preferably most and highly preferably all of the multiple pieces (2224a, 2224b) are made of a material having a first Coefficient of Thermal Expansion (CTE), wherein the first Coefficient of Thermal Expansion is different to a Coefficient of Thermal Expansion of polycrystalline SiC.

15. SiC growth substrate according to claim 14,
**characterized in that**
the multiple pieces (2224) comprise at least two pieces (2224a) of a main piece type and at least one piece of a connecting piece type (2224b), wherein the at least two main pieces (2224a) are coupled by the at least one connecting piece (2224b), wherein the pieces of the main piece type (2224a) have a tubular-like (2220) or rod-like (2218) or blade-like shape (2214) and wherein at least most of the pieces (2224a) of the main piece type are longer compared to the pieces (2224b) of the connecting piece type.

16. SiC growth substrate according to claim 15,
**characterized in that**
the length of each of the at least two pieces (2224a) of the main piece type is below 100cm and above 5cm
and
that at least two pieces of the main piece type (2224a) are made of graphite.

17. SiC growth substrate according to claim 15 or 16,
**characterized in that**
a first piece (2224a) of the at least two pieces of the main piece type has a first central axis (2230)
and
a second piece (2224a) of the at least two pieces of the main piece type has a second central axis (2232),
wherein the first central axis (2230) and the second central axis (2232) are arranged parallel to each other.

18. SiC growth substrate according to claims 4 to 17,
**characterized in that**
the physical structure forms a U-shape.

19. A CVD reactor (850),
wherein the CVD reactor (850) comprises a process chamber (856), wherein the process chamber (856) is at least surrounded by a base plate (862), a side wall section (864a) and a top wall section (864b),
a gas inlet unit (866) for feeding one feed-medium or multiple feed-mediums into a reaction space of the process chamber (856) for generating a source medium,
wherein the gas inlet unit (866) is coupled with at least one feed-medium source (851),
wherein a Si and C feed-medium source (851) provides at least Si and C, in particular SiCl3(CH3), and wherein a carrier gas feed-medium source (853) provides a carrier gas, in particular H2,
or
wherein the gas inlet unit (866) is coupled with at least two feed-medium sources (851, 852),
wherein a Si feed medium source (851) provides at least Si and wherein a C feed medium source (852) provides at least C, in particular natural gas, Methane, Ethane, Propane, Butane and/or Acetylene, and wherein a carrier gas medium source (853) provides a carrier gas, in particular H2,
one or multiple SiC growth substrate (857) according to claims 1 to 22, in particular more than 3 or 4 or 6 or 8 or 16 or 32 or 64 or up to 128 or up to 256, are arranged inside the process chamber (856) for depositing SiC,
wherein each SiC growth substrate (857) comprises a first power connection (859a) and a second power connection (859b),
wherein the first power connections (859a) are first metal electrodes (206a) and wherein the second power connections (859b) are second metal electrodes (206b),
wherein the first metal electrodes (206a) and the second metal electrodes (206b) are preferably shielded from the reaction space (966),
wherein each SiC growth substrate (857) is coupled between at least one first metal electrode (206a) and at least one second metal electrode (206b) for heating the outer surface of the SiC growth substrates (857) or the surface of the deposited SiC to temperatures between 1300°C and 1800°C, in particular by means of resistive heating and preferably by internal resistive heating.

20. Method for growing SiC, in particular on a SiC growth substrate (857) according to claims 1 to 18,
at least comprising the steps
Increasing current flow through the SiC growth substrate (857) over time to keep a temperature of a growth face in a defined temperature range,
Depositing SiC on the SiC growth substrate (857) and thereby forming a crust (211) of SiC,
Growing the crust (211) of SiC to a thickness of more than 1 cm,
Preventing cracking of the defined volume section of the SiC growth substrate (857) during the growth step by means of the physical structure of the main body (2200).
